# EUROPEAN PATENT APPLICATION

(11) **EP 3 196 265 A1**
(43) Date of publication of application: **26.07.2017**
(21) Application number: 16758941.5
(22) Date of filing: 02.03.2016
(51) Int. Cl.: C09J 7/02, C09J 201/00, H01L 21/301, H01L 21/52

(54) **FILM-LIKE ADHESIVE COMPOSITE SHEET AND METHOD FOR MANUFACTURING SEMICONDUCTOR DEVICE**

(30) Priority: 04.03.2015 JP 2015042647
(71) Applicant: LINTEC Corporation, Tokyo 173-0001 (JP)
(72) Inventor: SAGAWA Yuta, Tokyo 173-0001 (JP); FUSE Keishi, Tokyo 173-0001 (JP)
(74) Representative: V.O.
(86) International application number: PCT/JP2016/056379
(87) International publication number: WO 2016/140248

(57) **Abstract**

A film-like adhesive composite sheet including:
a support sheet having a base material; and
a curable film-like adhesive provided on the support sheet and having a thickness of 1 to 50 µm,
wherein a peel force at an interface between the support sheet and the film-like adhesive is from 0.02 to 0.2 N / 25 mm, and
the film-like adhesive has the following properties:
a breaking elongation of a laminated body obtained by laminating the film-like adhesive before curing so that the total thickness becomes 200 µm is equal to or less than 450%.

## Description

### Technical Field

The present invention relates to a film-like adhesive composite sheet and a method for manufacturing a semiconductor device using the same.

Priority is claimed on Japanese Patent Application No. 2015-042647, filed March 4, 2015, the content of which is incorporated herein by reference.

### Background Art

Among manufacturing processes of a semiconductor device, as one of the methods of obtaining a semiconductor chip to which a film-like adhesive for use in die bonding has been adhered, there is a method that includes a step of adhering a film-like adhesive to a plurality of semiconductor chips that have been divided already in advance by dicing, and then cutting the film adhesive. In this method, by using a film-like adhesive composite sheet in which a film-like adhesive has been provided on a support sheet, a piece of this film-like adhesive is adhered to a plurality of semiconductor chips. For example, a semiconductor chip is produced by forming a groove from the surface of a semiconductor wafer and grinding the back surface side until it reaches the groove. The semiconductor chip to which the film-like adhesive after cutting is adhered is pulled away (picked up) from the support sheet together with the film-like adhesive and used for die bonding.

In the above method, as a method of cutting the film-like adhesive, for example, a cutting method by irradiating laser light onto the film-like adhesive or a cutting method by expanding the support sheet has been known. However, in the method of irradiating laser light, a laser irradiation apparatus will be required, and there has also been a problem in that the cutting cannot be carried out efficiently in a short period of time. Further, with the expanding method, an expanding apparatus will be required, and there has also been a problem in that the cut surface may become rough. Furthermore, since the force is exerted only in the direction of the same surface as that of the film-like adhesive in the expanding method, there is a possibility that the film-like adhesive will only be extended together with the support sheet and will not be cut. For this reason, the film-like adhesive is sometimes cooled to facilitate cutting and expanding, but in this case, a cooling step will be required to lower the productivity.

As a method capable of solving these problems, a method to cut a film-like adhesive by using a film-like adhesive having a specific thickness and tensile elongation at break and utilizing the shear force generated when picking up the semiconductor chip has been disclosed (see Patent Document 1).

### Citation List

### Patent Documents

[Patent Document 1] Japanese Unexamined Patent Application, First Publication No. 2013-179317

### Summary of Invention

### Technical Problem

However, in Patent Document 1, for example, there is no description of the peel force at the interface between the support sheet and the film-like adhesive, and with this method, it is not certain whether the semiconductor chip to which the film-like adhesive after cutting is adhered can be reliably picked up from the support sheet.

The present invention has been developed in light of the above circumstances, and has an object of providing a film-like adhesive composite sheet in which a film-like adhesive is provided on a support sheet, so that a semiconductor chip to which the film-like adhesive is adhered can be separated from the support sheet by a simplified method at the time of manufacturing a semiconductor device; and a method for manufacturing a semiconductor device using this sheet.

### Solution to Problem

In order to solve the above problems, the present invention provides, for example, the following film-like adhesive composite sheets (1) to (3) and a method (4) for manufacturing a semiconductor device.
(1) A film-like adhesive composite sheet according to a first aspect of the present invention includes a support sheet having a base material and a curable film-like adhesive provided on the aforementioned support sheet and having a thickness of 1 to 50 µm,
   wherein a peel force at an interface between the aforementioned support sheet and the aforementioned film-like adhesive is from 0.02 to 0.2 N / 25 mm, and
   the aforementioned film-like adhesive has the following properties:
   a breaking elongation of a laminated body obtained by laminating the aforementioned film-like adhesive before curing so that the total thickness becomes 200 µm is equal to or less than 450%.
(2) In the film-like adhesive composite sheet of the above (1), the aforementioned support sheet may be composed of the aforementioned base material, and the aforementioned film-like adhesive may be provided on and in direct contact with the aforementioned base material.
(3) In the film-like adhesive composite sheet of the above (1) or (2), a peel force at an interface between the aforementioned support sheet and the aforementioned film-like adhesive in a state where the aforementioned film-like adhesive composite sheet is not irradiated with an energy ray may be from 0.02 to 0.2 N / 25 mm.
(4) A method for manufacturing a semiconductor device according to a first aspect of the present invention includes:
   a step of adhering the film-like adhesive composite sheet of any one of the above (1) to (3) to a plurality of already divided semiconductor chips via a film-like adhesive;
   a step of applying a force to a support sheet of the aforementioned film-like adhesive composite sheet adhered to the aforementioned semiconductor chip from a side opposite to a side provided with the film-like adhesive, thereby applying a force to the film-like adhesive through the support sheet and cutting the film-like adhesive; and
   a step of separating the aforementioned semiconductor chip and the aforementioned film-like adhesive adhered thereon, after cutting, from the aforementioned support sheet.

### Advantageous Effects of Invention

According to the present invention, a film-like adhesive composite sheet in which a film-like adhesive is provided on a support sheet, so that a semiconductor chip to which the film-like adhesive is adhered can be separated from the support sheet by a simplified method at the time of manufacturing a semiconductor device; and a method for manufacturing a semiconductor device using this sheet are provided.

### Brief Description of Drawings

FIG. 1 is a cross-sectional view schematically illustrating one embodiment from cutting of a film-like adhesive to separation of a semiconductor chip from a support sheet in the manufacturing method according to the present invention.
FIG. 2 is a cross-sectional view schematically illustrating one aspect of a film-like adhesive composite sheet and a semiconductor chip in a manufacturing process of a semiconductor device when a conventional film-like adhesive composite sheet is used.
FIG. 3 is a cross-sectional view schematically illustrating another aspect of a film-like adhesive composite sheet and a semiconductor chip in a manufacturing process of a semiconductor device when a conventional film-like adhesive composite sheet is used.
FIG. 4 is a cross-sectional view schematically illustrating yet another aspect of a film-like adhesive composite sheet and a semiconductor chip in a manufacturing process of a semiconductor device when a conventional film-like adhesive composite sheet is used.
FIG. 5 is a cross-sectional view schematically illustrating yet another aspect of a film-like adhesive composite sheet and a semiconductor chip in a manufacturing process of a semiconductor device when a conventional film-like adhesive composite sheet is used.
FIG. 6 is a cross-sectional view schematically illustrating one embodiment of a film-like adhesive composite sheet according to the present invention.
FIG. 7 is a cross-sectional view schematically illustrating one embodiment of a film-like adhesive composite sheet according to the present invention.

### Description of Embodiments

### «Film-like adhesive composite sheet»

A film-like adhesive composite sheet according to the present invention is a film-like adhesive composite sheet provided with a curable film-like adhesive having a thickness of 1 to 50 µm on a support sheet having a base material, and characterized in that a peel force at an interface between the aforementioned support sheet and the aforementioned film-like adhesive is from 0.02 to 0.2 N / 25 mm, and the aforementioned film-like adhesive has the following characteristics: a breaking elongation of a laminated body obtained by laminating the aforementioned film-like adhesive before curing so that the total thickness becomes 200 µm is equal to or less than 450%.

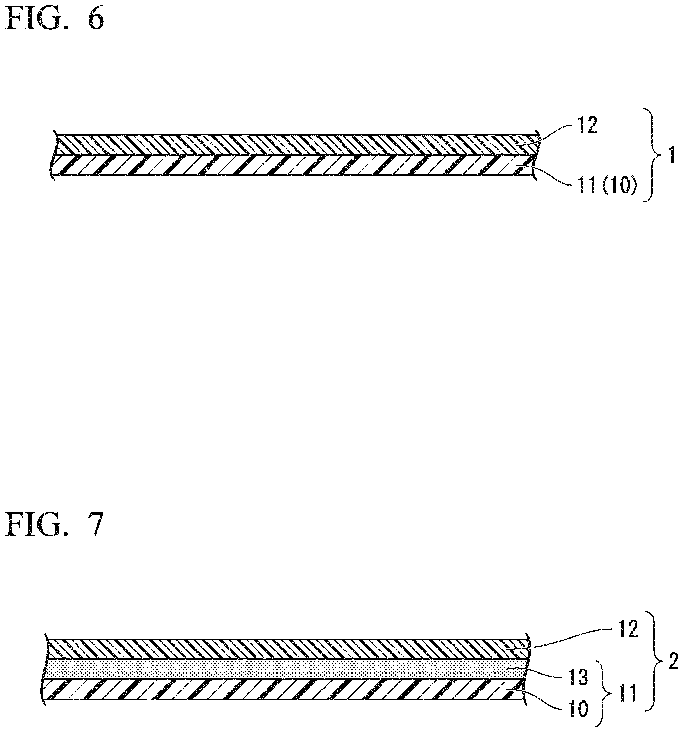

FIG. 6 is a cross-sectional view schematically illustrating one embodiment of the film-like adhesive composite sheet according to the present invention. A film-like adhesive composite sheet 1 according to the present invention includes a support sheet 11 having a base material 10 and a curable film-like adhesive 12 provided on the support sheet 11 and having a thickness of 1 to 50 µm. The support sheet 11 of the film-like adhesive composite sheet 1 shown in FIG. 6 is composed of the base material 10.

FIG. 7 is a cross-sectional view schematically illustrating one embodiment of the film-like adhesive composite sheet according to the present invention. A film-like adhesive composite sheet 2 according to the present invention includes a support sheet 11 having a base material 10, a curable film-like adhesive 12 provided on the support sheet 11 and having a thickness of 1 to 50 µm, and a pressure-sensitive adhesive layer 13 provided on the base material 10, and the film-like adhesive 12 is provided on the pressure-sensitive adhesive layer 13. The support sheet 11 of the film-like adhesive composite sheet 1 shown in FIG. 7 includes the base material 10 and the pressure-sensitive adhesive layer 13.

The film-like adhesive composite sheet is used by adhering the film-like adhesive to one side of a semiconductor chip (mainly, a side opposite to a circuit side (back side)) at the time of manufacturing a semiconductor device. In a later step, the semiconductor chip is pulled away (picked up) from the support sheet while the film-like adhesive remains adhered thereto.

At this time, since the breaking elongation of the film-like adhesive composite sheet and the thickness of the film-like adhesive are within predetermined ranges, by performing a normal operation of applying a force to the film-like adhesive through the support sheet, it is possible to reliably cut the film-like adhesive at an intended place at normal temperature without separately providing a step mainly for cutting the film-like adhesive. Therefore, it is possible to suppress poor separation (lifting) of the semiconductor chip due to the film-like adhesive not being cut.

In addition, since the peel force of the film-like adhesive composite sheet is within a predetermined range, a portion of the film-like adhesive corresponding to the intended semiconductor chip is reliably peeled off from the support sheet, and also a phenomenon in which a portion of the film-like adhesive corresponding to an unintended semiconductor chip is peeled off from the support sheet is suppressed. Therefore, poor separation (lifting) of the semiconductor chip due to the intended portion of the film-like adhesive not being peeled off from the support sheet, and the occurrence of the so-called doubled dies in which not only the intended semiconductor chip but also the semiconductor chip adjacent to this semiconductor chip together with the film-like adhesive are separated at the same time from the support sheet can be suppressed.

As described above, the film-like adhesive composite sheet suppresses poor separation of the semiconductor chip and the occurrence of doubled dies by specifying the breaking elongation, the thickness of the film-like adhesive and the peel force. Further, by using the film-like adhesive composite sheet, it is possible to omit steps mainly for cutting the film-like adhesive as described above, for example, a step of irradiating a laser beam to cut the film-like adhesive, a step of expanding and thereby cutting the film-like adhesive, or the like. For this reason, it is possible to avoid problems caused by performing these steps, and also to cut the film-like adhesive at normal temperature and to reduce the number of steps. Therefore, a semiconductor device can be manufactured in a simplified manner.

It should be noted that in the present specification, the expression "expansion of the film-like adhesive" means expansion of the film-like adhesive in the direction parallel to its surface.

On the other hand, although the use of a film-like adhesive having a specific thickness and tensile elongation at break has been disclosed in the above-mentioned "Japanese Unexamined Patent Application, First Publication No. 2013-179317" (Patent Document 1), there is no description of the peel force at the interface between the support sheet and the film-like adhesive. Although a film-like adhesive composite sheet formed by providing a film-like adhesive on a general dicing sheet (a support sheet having a base material and a pressure-sensitive adhesive layer) has been specifically disclosed in Examples, there is no description that the effects of the present invention as described above can be achieved.

### <Support sheet>

The support sheet has a base material, and may be consisted of a base material (having only a base material), or may have a base material and a material other than the base material. As a support sheet having a material other than the base material, a support sheet having a pressure-sensitive adhesive layer on a base material can be exemplified.

A film-like adhesive described later is provided on the support sheet. For example, when a support sheet having a pressure-sensitive adhesive layer on a base material is used, the film-like adhesive is provided on the pressure-sensitive adhesive layer.

### [Base material]

The material of the base material is preferably various resins, and specific examples thereof include polyethylenes (low density polyethylenes (LDPE), linear low density polyethylenes (LLDPE), high density polyethylenes (HDPE or the like)), polypropylenes, polybutenes, polybutadienes, polymethylpentenes, styrene/ethylenebutylene/styrene block copolymers, polyvinyl chlorides, vinyl chloride copolymers, polyethylene terephthalates, polybutylene terephthalates, polyurethanes, polyurethane acrylates, polyimides, ethylene vinyl acetate copolymers, ionomer resins, ethylene/(meth)acrylic acid copolymers, ethylene/(meth)acrylate copolymers, polystyrenes, polycarbonates, fluororesins, and hydrogenated products, modified products, crosslinked products or copolymers of any of these resins.

It should be noted that in the present specification, the term "(meth)acrylic acid" is a concept that includes both "acrylic acid" and "methacrylic acid".

The base material may be composed of one layer (single layer) or two or more layers (a plurality of layers). In the case where the base material is composed of a plurality of layers, the materials of the respective layers may all be the same, may all be different, or only a portion thereof may be the same.

The thickness of the base material can be appropriately selected depending on the purpose, but it is preferably from 50 to 300 µm, and more preferably from 60 to 100 µm. In the case where the base material is composed of a plurality of layers, it is preferable that the total thickness of all layers is within such a numerical range.

The "thickness of the base material" referred to here is a value expressed as an average obtained by measuring the thickness at five places selected arbitrarily.

When providing a pressure-sensitive adhesive layer on the base material, for the purpose of improving adhesive properties to the pressure-sensitive adhesive layer or the like, the surface of the base material may be subjected to a roughening treatment by a sandblasting treatment, a solvent treatment or the like, or an oxidation treatment such as a corona discharge treatment, an electron beam irradiation treatment, a plasma treatment, an ozone/ultraviolet irradiation treatment, a flame treatment, a chromic acid treatment, a hot air treatment or the like. Further, the surface of the base material may be subjected to a primer treatment. In addition, the base material may have a layer for preventing adhesion of the base material to other sheets and adhesion of the base material to the adsorption table or the like, when an antistatic coating layer and the film-like adhesive composite sheet are superposed and stored.

Among these, from the viewpoint of suppressing the occurrence of fragments of the base material due to friction of a blade during dicing, the base material whose surface has been subjected to an electron beam irradiation treatment is particularly preferable.

### [Pressure-sensitive adhesive layer]

As the pressure-sensitive adhesive layer, commonly known ones can be appropriately used.

The pressure-sensitive adhesive layer can be formed by using a pressure-sensitive adhesive composition containing various components for constituting the pressure-sensitive adhesive layer. The ratio of the contents of nonvolatile components to each other in the pressure-sensitive adhesive composition is also the same in the pressure-sensitive adhesive layer.

In the case where the pressure-sensitive adhesive layer contains a component to be polymerized by the irradiation of energy rays, it is possible to pick up a semiconductor chip by irradiating an energy ray to reduce its tackiness. A treatment of reducing the tackiness by irradiating the pressure-sensitive adhesive layer with an energy ray may be performed after the film-like adhesive composite sheet is adhered to an adherend, or may be performed in advance before the adhesion to the adherend.

As the energy ray, typically, ultraviolet rays, electron rays, and the like are used. The irradiation dose of energy rays differs depending on the type of energy rays, but in the case of ultraviolet rays, for example, the light amount is preferably from 50 to 1,000 mJ/cm², and more preferably from 100 to 500 mJ/cm². In addition, in the case of electron rays, it is preferably about 10 to 1,000 krad.

Preferable examples of the pressure-sensitive adhesive composition include those containing an acrylic polymer and an energy ray-polymerizable compound (pressure-sensitive adhesive composition (i)), and those containing an acrylic polymer having a hydroxyl group and having a polymerizable group in a side chain (for example, one having a hydroxyl group and having a polymerizable group in the side chain via a urethane bond) and an isocyanate-based crosslinking agent (pressure-sensitive adhesive composition (ii)), and those further containing a solvent are preferable.

In addition to the components described above, the pressure-sensitive adhesive composition may further contain any one of various additives such as a photopolymerization initiator, a dye, a pigment, a deterioration inhibitor, an antistatic agent, a flame retardant, a silicone compound, a chain transfer agent.

In addition, the pressure-sensitive adhesive composition may contain a reaction retarder for suppressing the unintended crosslinking reaction during storage. Examples of the reaction retarder include those which inhibit the action of a component serving as a catalyst for promoting a crosslinking reaction, and preferable examples thereof include those which form a chelate complex by chelation with respect to the catalyst. Specific examples of preferable reaction retarders include those having two or more carbonyl groups (-C(=O)-) in the molecule, and examples of the two carbonyl groups in the molecule include dicarboxylic acid, keto acid, diketone and the like.

The thickness of the pressure-sensitive adhesive layer can be appropriately selected depending on the purpose, but it is preferably from 1 to 100 µm, more preferably from 1 to 60 µm, and particularly preferably from 1 to 30 µm.

The "thickness of the pressure-sensitive adhesive layer" referred to here is a value expressed as an average of thicknesses measured at five places selected arbitrarily.

The pressure-sensitive adhesive composition can be obtained by blending each component for constituting the pressure-sensitive adhesive layer, such as an acrylic polymer, and can be obtained, for example, by the same method as in the case of the adhesive composition described later, except that the blended components are different.

The pressure-sensitive adhesive layer can be formed by applying a pressure-sensitive adhesive composition containing each component for constituting the pressure-sensitive adhesive layer and a solvent on the surface of the base material, and drying to evaporate the solvent.

At this time, if necessary, crosslinking may be carried out by heating the applied pressure-sensitive adhesive composition. The heating condition can be set, for example, from 100 to 130°C for 1 to 5 minutes, but is not limited thereto. Further, the pressure-sensitive adhesive layer can also be formed on the base material by pasting, onto the surface of the base material, a pressure-sensitive adhesive layer formed by applying and drying the pressure-sensitive adhesive composition on the surface of a release layer of a release material, and then removing the release material.

Coating of the pressure-sensitive adhesive composition onto the surface of the base material or the surface of the release layer of the release material may be carried out by a known method, and a method using various coaters such as an air knife coater, a blade coater, a bar coater, a gravure coater, a roll coater, a roll knife coater, a curtain coater, a die coater, a knife coater, a screen coater, a Meyer bar coater and a kiss coater can be exemplified.

### <Film-like adhesive>

The film-like adhesive exhibits curability (thermosetting properties), and preferably further exhibits pressure-sensitive adhesive properties. In an uncured state, the film-like adhesive having both pressure-sensitive adhesive properties and thermosetting properties can be pasted by lightly pressing it against various adherends. Further, the film-like adhesive may be one that can be adhered to various adherends by heating and softening. The film-like adhesive finally becomes a cured product having high impact resistance through thermal curing, and such a cured product is also excellent in shear strength and can retain sufficient adhesive properties even under severe high temperature and high humidity conditions.

The thickness of the film-like adhesive is from 1 to 50 µm, preferably from 3 to 25 µm, and more preferably from 5 to 15 µm. By ensuring that the thickness of the film-like adhesive is equal to or more than the above-mentioned lower limit value, a sufficient adhesive force to the adherend (semiconductor chip) can be obtained. In addition, by ensuring that the thickness of the film-like adhesive is equal to or less than the above upper limit value, it is possible to easily cut the film-like adhesive by performing an operation of applying a force to the film-like adhesive through the support sheet, which is normally performed at the time of manufacturing a semiconductor device, and utilizing the shearing force generated by this operation, and there is no need to separately provide a step mainly for cutting the film-like adhesive.

The "thickness of the film-like adhesive" referred to here is a value represented by an average of thicknesses measured at five places selected arbitrarily.

When formed into a test piece having a thickness of 200 µm, the film-like adhesive has a breaking elongation (tensile elongation at break) before curing of 450% or less, preferably 445% or less. By ensuring that the breaking elongation equal to or less than the above upper limit value, it is possible to easily and reliably cut the film-like adhesive at an intended place by performing an operation of applying a force to the film-like adhesive through the support sheet as described above, and there is no need to separately provide a step mainly for cutting the film-like adhesive.

The lower limit value of the breaking elongation is not particularly limited. However, the breaking elongation is preferably 50% or more, and more preferably 100% or more, from the viewpoint that the film-like adhesive composite sheet can be handled more stably.

A breaking elongation (tensile elongation at break) before curing of a test piece of the film-like adhesive having a thickness of 200 µm is preferably 50% or more and 450% or less, and more preferably 100% or more and 445% or less.

It should be noted that in the present specification, the expression "the breaking elongation is X% (in the formula, X is a positive number)" means that in the measuring method described later, when a laminated body is pulled and the laminated body is extended in its tensile direction by a length of X% of the original length (the length when no pulling is performed), that is, when the total length of the laminated body in the tensile direction becomes [1 + X/100] times the length before the pulling, the laminated body fractures.

The breaking elongation of the film-like adhesive can be appropriately adjusted by adjusting the type and amount of the component contained therein. For example, the breaking elongation of the film-like adhesive can be adjusted, by adjusting the molecular weight and content of a polymer component (a) described later as the component contained therein, the structure, softening point and content of the component constituting an epoxy-based thermosetting resin (b), the content of a filler (c) or the like, but this is only an example.

The test piece of the film-like adhesive which satisfies the conditions of the breaking elongation may have a thickness of 200 µm, but usually, a laminated body in which two or more film-like adhesives before curing having a thickness of less than 200 µm, preferably film-like adhesives before curing having a thickness of 1 to 50 µm for constituting the film-like adhesive composite sheet according to the present invention, are laminated so that the total thickness becomes 200 µm is used as the test piece.

Since the breaking elongation increases as the thickness of the film-like adhesive increases, if the breaking elongation of a test piece of the film-like adhesive having a thickness of less than 200 µm is 450% or less, the breaking elongation of a test piece of the film-like adhesive having the same composition and a thickness of 200 µm is also naturally 450% or less.

The breaking elongation was determined by fixing, as a test piece, a laminated body of a film-like adhesive having a width of 15 mm, a length of 100 mm and a thickness of 200 µm at two points so that the distance between the fixed points is 75 mm, pulling the test piece at a tension rate of 200 mm/min within these fixed points, and measuring the elongation of the test piece when the test piece fractures.

The peel force at the interface between the support sheet and the film-like adhesive is from 0.02 to 0.2 N / 25 mm, preferably from 0.02 to 0.15 N / 25 mm, and more preferably from 0.02 to 0.1 N / 25 mm. By ensuring that the peel force is equal to or more than the above lower limit value, when separating the semiconductor chip from the support sheet together with the film-like adhesive, a phenomenon in which the film-like adhesive is peeled off from the support sheet, not only at a portion corresponding to the intended semiconductor chip to be separated, but also at a portion corresponding to the unintended semiconductor chip, such as one adjacent to this intended semiconductor chip at the same time, is suppressed. In addition, by ensuring that the peel force is equal to or less than the above upper limit value, when the semiconductor chip is separated from the supporting sheet together with the film-like adhesive, a portion corresponding to the intended semiconductor chip of the film-like adhesive is reliably peeled off from the support sheet. Since it is reliably peeled off in this manner, when applying a force to the film-like adhesive through the support sheet as described later, it is unnecessary to modify the conditions, for example, by making the conditions stricter (for example, by increasing the moving speed of a jig for applying the force) when separating the semiconductor chip, and the occurrence of cracks and the like of the semiconductor chip as seen when such modifications are made is suppressed.

The peel force can be appropriately adjusted, for example, by adjusting the type and amount of the component contained in the film-like adhesive, the material constituting the surface of the support sheet on which the film-like adhesive is provided, the state of this surface or the like.

Further, with respect to the film-like adhesive, there is a tendency that when the breaking elongation is large, the peel force also increases, and when the breaking elongation is small, the peel force also decreases.

The peel force can be determined by setting a state in which a film-like adhesive composite sheet having a width of 25 mm and an arbitrary length is adhered to an adherend by the film-like adhesive, and, when peeling off the support sheet from the film-like adhesive adhered to the adherend at a peeling rate of 300 mm/min, measuring a force (peel force) that is applied when the support sheet is peeled off (180° peeling is carried out) in the longitudinal direction thereof (longitudinal direction of the film-like adhesive composite sheet), so that the surfaces in contact with each other of the film-like adhesive and the support sheet form an angle of 180°. The length of the film-like adhesive composite sheet to be measured is not particularly limited as long as it is within the range so that the measuring force can be stably detected, but it is preferably from 200 to 300 mm. The peel force can be obtained by measuring under conditions of a temperature of 25°C and a relative humidity of 50%. In addition, during measurement, it is preferable to bring the film-like adhesive composite sheet into a state of being adhered to the adherend and to allow the resultant to stand for 30 minutes under the conditions of a temperature of 25°C and a relative humidity of 50%, thereby stabilizing the adhered state of the film-like adhesive composite sheet.

When the film-like adhesive contains an energy ray-curable resin (h) described later, or the support sheet has a pressure-sensitive adhesive layer, the pressure-sensitive adhesive layer contains a component that polymerizes by irradiation of energy rays, and the film-like adhesive or the support sheet is not yet irradiated with energy rays, values of the peel force at the interface between the support sheet and the film-like adhesive become different before and after irradiating the film-like adhesive with energy rays. However, in the present invention, it suffices as long as any value before and after the energy ray irradiation falls within the above range. In this case, it is possible to adhere the film-like adhesive composite sheet to a plurality of already divided semiconductor chips via a film-like adhesive, and then to irradiate the film-like adhesive composite sheet with energy rays, thereby adjusting the peel force at the interface between the support sheet and the film-like adhesive within the above range. Therefore, in this case, the value after the energy ray irradiation usually may be within the above range. However, introduction of a step of irradiating energy rays to a film-like adhesive composite sheet to a manufacturing method of a semiconductor device leads to a decrease in productivity. Therefore, regardless of whether or not the film-like adhesive contains the energy ray-curable resin (h), or the pressure-sensitive adhesive layer of the support sheet contains a component to be polymerized by irradiation of energy rays, the peel force at the interface between the support sheet and the film-like adhesive is preferably within the above range in a state where no energy ray has been irradiated to the film-like adhesive composite sheet.

The film-like adhesive is not particularly limited as long as it satisfies the above-mentioned conditions.

Preferred examples of the film-like adhesives include those containing a polymer component (a) and those containing a thermosetting resin (b).

Examples of the thermosetting resin (b) include an epoxy-based thermosetting resin, a thermosetting polyimide, a polyurethane, an unsaturated polyester, a silicone resin and the like, and an epoxy-based thermosetting resin is preferable.

The film-like adhesive can be produced, for example, by applying an adhesive composition containing a component for constituting this film-like adhesive and a solvent to the surface of a release film and drying to volatilize the solvent to form a film. The ratio of the contents of nonvolatile components to each other in the adhesive composition is also the same in the film-like adhesive.

### [Adhesive composition]

Preferred examples of the adhesive composition include those containing the polymer component (a) and the epoxy-based thermosetting resin (b). Each component will be described below.

### (Polymer component (a))

The polymer component (a) is a component which can be regarded as being formed by a polymerization reaction of a polymerizable compound, and it is a polymer compound for imparting film-forming properties, flexibility and the like to the film-like adhesive, and at the same time, improving adhesiveness (sticking property) to an adhesion target such as a semiconductor chip. Further, the polymer component (a) is also a component which does not correspond to an epoxy resin (b1 and a thermal curing agent (b2) which will be described later.

One type of the polymer component (a) may be used alone, or two or more types thereof may be used in combination.

As the polymer component (a), an acrylic resin, a polyester resin, a urethane resin, an acrylic urethane resin, a silicone resin, a rubber-based polymer, a phenoxy resin and the like can be used, and an acrylic resin is preferable.

As the acrylic resin, a known acrylic polymer can be used.

The weight average molecular weight (Mw) of the acrylic resin is preferably from 10,000 to 2,000,000, and more preferably from 100,000 to 1,500,000. When the weight average molecular weight of the acrylic resin is in such a range, it is easy to adjust the peel force at the interface between the support sheet and the film adhesive to the above-mentioned range. Further, if the weight average molecular weight of the acrylic resin is too large, the film-like adhesive may not follow the uneven surface of the adherend, which may cause voids and the like.

It should be noted that in the present specification, the "weight average molecular weight" is a polystyrene equivalent value measured by a gel permeation chromatography (GPC) method, unless otherwise specified.

The glass transition temperature (Tg) of the acrylic resin is preferably from -60 to 70°C, and more preferably from -30 to 50°C. If the Tg of the acrylic resin is too low, the peel force between the film-like adhesive and the support sheet becomes large, which may result in poor separation of the semiconductor chip from the support sheet. In addition, if the Tg of the acrylic resin is too high, the adhesive force for fixing the semiconductor chip may become insufficient.

Examples of the monomer constituting the acrylic resin include (meth)acrylic acid esters including alkyl (meth)acrylates having a linear alkyl group of 1 to 18 carbon atoms, such as methyl (meth)acrylate, ethyl (meth)acrylate, propyl (meth)acrylate, butyl (meth)acrylate, 2-ethylhexyl (meth)acrylate, isooctyl (meth)acrylate, n-octyl (meth)acrylate, n-nonyl (meth)acrylate, isononyl (meth)acrylate, decyl (meth)acrylate, undecyl (meth)acrylate, dodecyl (meth)acrylate (lauryl (meth)acrylate), tridecyl (meth)acrylate, tetradecyl (meth)acrylate (myristyl (meth)acrylate), pentadecyl (meth)acrylate, hexadecyl (meth)acrylate (palmityl (meth)acrylate), heptadecyl (meth)acrylate and octadecyl (meth)acrylate (stearyl (meth)acrylate);
(meth)acrylates having a cyclic skeleton such as cycloalkyl (meth)acrylate, benzyl (meth)acrylate, isobornyl (meth)acrylate, dicyclopentanyl (meth)acrylate, dicyclopentenyl (meth)acrylate, dicyclopentenyloxyethyl (meth)acrylate and imide (meth)acrylate;
hydroxyl group-containing (meth)acrylates such as hydroxymethyl (meth)acrylate, 2-hydroxyethyl (meth)acrylate and 2-hydroxypropyl (meth) acrylate; and glycidyl group-containing (meth)acrylates such as glycidyl (meth)acrylate.

That is, the acrylic resin is a resin containing a structural unit derived from the monomer. The expression "derived" as used herein means that the monomer undergoes a change in the structure required for polymerization.

Further, the acrylic resin may be those obtained by copolymerization of monomers such as acrylic acid, methacrylic acid, itaconic acid, vinyl acetate, acrylonitrile, styrene and N-methylolacrylamide.

It should be noted that in the present specification, the term "(meth)acrylate" is a concept including both "acrylate" and "methacrylate".

The acrylic resin may be constituted of only one type of monomer, or two or more types of monomers.

The acrylic resin may have a functional group capable of bonding with another compound, such as a vinyl group, a (meth)acryloyl group, an amino group, a hydroxyl group, a carboxyl group and an isocyanate group. The bonding with another compound may be carried out via a crosslinking agent (f) which will be described later, or the aforementioned functional group may be directly bonded to another compound without interposing the crosslinking agent (f). The reliability of the semiconductor package tends to improve due to the bonding of the acrylic resin with another compound through these functional groups.

The proportion of the content of the acrylic resin with respect to the total content of the solid content of the adhesive composition (the content of the acrylic resin of the film-like adhesive) is preferably from 5 to 40% by mass, and more preferably from 7 to 25% by mass.

In the present invention, in order to improve the releasability of the film-like adhesive from the support sheet, so that the semiconductor chip provided with the film-like adhesive can be separated from the support sheet in a favorable manner, and to suppress the occurrence of voids or the like due to the film-like adhesive following the uneven surface of the adherend, as the polymer component (a), a thermoplastic resin other than an acrylic resin (hereinafter, sometimes abbreviated simply as "thermoplastic resin") may be used alone, or may be used in combination with an acrylic resin.

The thermoplastic resin preferably has a weight average molecular weight of 1,000 to 100,000, more preferably 3,000 to 80,000.

The glass transition temperature (Tg) of the thermoplastic resin is preferably from -30 to 150°C, and more preferably from -20 to 120°C.

Examples of the thermoplastic resin include polyesters, urethane resins, phenoxy resins, polybutenes, polybutadienes and polystyrenes.

One type of the thermoplastic resin may be used alone, or two or more types thereof may be used in combination.

While the effects as described above can be obtained by using the thermoplastic resin, there is concern that when the film-like adhesive before curing is exposed to high temperature, the hardness is lowered, and the wire bonding suitability of the film-like adhesive in an uncured or semi-cured state is lowered. Accordingly, it is preferable to set the content of the acrylic resin in the adhesive composition in consideration of such adverse effects.

The proportion of the content of the polymer component (a) with respect to the total content of the solid content of the adhesive composition (the content of the acrylic resin of the film-like adhesive) is preferably from 5 to 85% by mass, and more preferably from 7 to 80% by mass regardless of the type of the polymer component (a).

### (Thermosetting resin (b))

Examples of the thermosetting resin (b) include an epoxy-based thermosetting resin, a thermosetting polyimide, a polyurethane, an unsaturated polyester, a silicone resin and the like, and an epoxy-based thermosetting resin is preferable.

The epoxy-based thermosetting resin (b) is composed of an epoxy resin (b1 and a thermal curing agent (b2).

One type of the epoxy-based thermosetting resin (b) may be used alone, or two or more types thereof may be used in combination.

### - Epoxy resin (b1

Examples of the epoxy resin (b1) include known epoxy compounds, and specific examples thereof include bifunctional or higher epoxy compounds, such as a polyfunctional epoxy resin, a biphenyl compound, a bisphenol A diglycidyl ether and a hydrogenated product thereof, an orthocresol novolac epoxy resin, a dicyclopentadiene type epoxy resin, a biphenyl type epoxy resin, a bisphenol A type epoxy resin, a bisphenol F type epoxy resin and a phenylene skeleton type epoxy resin.

Further, as the epoxy resin (b1), an epoxy resin having an unsaturated hydrocarbon group may be used. As the epoxy resin having an unsaturated hydrocarbon group, a compound in which a portion of an epoxy resin of a polyfunctional epoxy resin has been converted into a group containing an unsaturated hydrocarbon group can be exemplified. Such a compound can be produced, for example, by subjecting an epoxy group to an addition reaction with acrylic acid.

From the viewpoint of facilitating adjustment of the peel force at the interface between the support sheet and the film-like adhesive to the above-mentioned range, the epoxy resin (b1 preferably contains at least one selected from the group consisting of a liquid epoxy resin, a semisolid epoxy resin and a solid epoxy resin having a softening point of 80°C or less, or a combination of two or more thereof. From such a viewpoint, the proportion of the total content (mass) of the liquid epoxy resin, the semisolid epoxy resin and the solid epoxy resin having a softening point of 80°C or less in the total amount (mass) of the epoxy resin (b1 contained in the film-like adhesive is preferably from 45 to 100% by mass, and more preferably from 80 to 100% by mass. In particular, when the support sheet is composed of a base material and the film-like adhesive is provided in direct contact with the base material, by ensuring that the film-like adhesive contains at least one selected from the group consisting of a liquid epoxy resin, a semisolid epoxy resin and a solid epoxy resin having a softening point of 80°C or less, or a combination of two or more thereof, it becomes easy to set the peel force at the interface between the support sheet and the film-like adhesive to be equal to or more than the lower limit of the above-mentioned range.

The number average molecular weight of the epoxy resin (b1 is not particularly limited, but is preferably from 300 to 15,000, more preferably from 400 to 3,000, and particularly preferably from 500 to 1,200 from the viewpoints of curability of the film-like adhesive and strength and heat resistance after curing.

The epoxy equivalent of the epoxy resin (b1) is preferably from 100 to 1,000 g/eq, and more preferably from 300 to 800 g/eq.

One type of the epoxy resin (b1 may be used alone, or two or more types thereof may be used in combination.

### - Thermal curing agent (b2)

The thermal curing agent (b2) functions as a curing agent for the epoxy resin (b1).

As the thermal curing agent (b2), compounds having two or more functional groups capable of reacting with epoxy groups in one molecule can be exemplified. Examples of the functional group include a phenolic hydroxyl group, an alcoholic hydroxyl group, an amino group, a carboxyl group and a group in which an acid group is made anhydrous, and a phenolic hydroxyl group, an amino group or a group in which an acid group is made anhydrous is preferred, a phenolic hydroxyl group or an amino group is more preferred, and a phenolic hydroxyl group is particularly preferred.

Among the thermal curing agent (b2), examples of the phenolic curing agent (curing agent having a phenolic hydroxyl group) include polyfunctional phenolic resins, biphenol, novolac-type phenolic resins, dicyclopentadiene-based phenolic resins and aralkylphenolic resins.

Among the thermal curing agent (b2), examples of the amine-based curing agent (curing agent having an amino group) include DICY (dicyandiamide) and the like.

The thermal curing agent (b2) may have an unsaturated hydrocarbon group.

As the thermal curing agent (b2) having an unsaturated hydrocarbon group, a compound obtained by substituting a part of the hydroxyl group of the phenol resin with a group containing an unsaturated hydrocarbon group, a compound in which a group containing an unsaturated hydrocarbon group is directly bonded to an aromatic ring of the phenol resin, and the like can be exemplified. The unsaturated hydrocarbon group in the thermal curing agent is the same as the unsaturated hydrocarbon group in the above-mentioned epoxy resin having an unsaturated hydrocarbon group.

When a phenolic curing agent is used as the thermal curing agent (b2), from the viewpoint of facilitating adjustment of the peel force at the interface between the support sheet and the film-like adhesive within the above-mentioned range, those having a high softening point or glass transition temperature are preferred.

The number average molecular weight of the thermal curing agent (b2) is preferably from 300 to 30,000, more preferably from 400 to 10,000, and particularly preferably from 500 to 3,000.

One type of the thermal curing agent (b2) may be used alone, or two or more types thereof may be used in combination.

The proportion of the content of the thermal curing agent (b2) in the adhesive composition (the film-like adhesive) is preferably from 0.1 to 500 parts by mass, and more preferably from 1 to 200 parts by mass, with respect to 100 parts by mass of the content of the epoxy resin (b1). If the content of the thermal curing agent (b2) is too small, adhesive properties may not be obtained due to insufficient curing, and if the content of the thermal curing agent (b2) is excessive, the moisture absorption rate of the film-like adhesive increases, and the reliability of the semiconductor package may decrease.

The proportion of the content of the epoxy-based thermosetting resin (b) in the adhesive composition (the film-like adhesive) is preferably from 50 to 1,000 parts by mass, more preferably from 100 to 900 parts by mass, still more preferably from 150 to 800 parts by mass, and particularly preferably from 500 to 800 parts by mass, with respect to 100 parts by mass of the content of the polymer component (a). By ensuring that the content of the epoxy-based thermosetting resin (b) is in such a range, it becomes easy to adjust the peel force at the interface between the support sheet and the film-like adhesive within the above-mentioned range.

In addition to the polymer component (a) and the epoxy-based thermosetting resin (b), the film-like adhesive may contain other components that do not correspond to these, if necessary, in order to improve various physical properties thereof.

Preferable examples of the other components contained in the film-like adhesive include a curing accelerator (c), a filler (d), a coupling agent (e), a crosslinking agent (f), another thermosetting resin (g) that does not correspond to the epoxy resin, an energy ray-curable resin (h), a photopolymerization initiator (i), a general purpose additive (j), and the like.

That is, the film-like adhesive according to an embodiment of the present invention contains the polymer component (a), the epoxy-based thermosetting resin (b), and, according to need, at least one component selected from the group consisting of the curing accelerator (c), the filler (d), the coupling agent (e), the crosslinking agent (f), the another thermosetting resin (g) that does not correspond to the epoxy resin, the energy ray-curable resin (h), the photopolymerization initiator (i) and the general purpose additive (j).

The film-like adhesive contains, for example, one or more of the above-mentioned components so that the total content (% by mass) does not exceed 100% by mass.

### (Curing accelerator (c))

The curing accelerator (c) is used for adjusting the curing rate of the adhesive composition.

Preferable examples of the curing accelerator (c) include tertiary amines such as triethylenediamine, benzyldimethylamine, triethanolamine, dimethylaminoethanol and tris(dimethylaminomethyl) phenol; imidazoles (imidazoles in which one or more hydrogen atoms are substituted with a group other than hydrogen atoms) such as 2-methylimidazole, 2-phenylimidazole, 2-phenyl-4-methylimidazole, 2-phenyl-4,5-dihydroxymethylimidazole and 2-phenyl-4-methyl-5-hydroxymethylimidazole; organic phosphines (phosphines in which one or more hydrogen atoms are substituted with an organic group) such as tributylphosphine, diphenylphosphine and triphenylphosphine; and tetraphenylborates such as tetraphenylphosphonium tetraphenylborate and triphenylphosphine tetraphenylborate.

One type of the curing accelerator (c) may be used alone, or two or more types thereof may be used in combination.

When the curing accelerator (c) is used, the proportion of the content of the curing accelerator (c) in the adhesive composition (the film-like adhesive) is preferably from 0.01 to 10 parts by mass, and more preferably from 0.1 to 5 parts by mass, with respect to 100 parts by mass of the content of the epoxy-based thermosetting resin (b). By ensuring that the content of the curing accelerator (c) is in such a range, the film-like adhesive exhibits excellent adhesive properties even under high temperature and high humidity conditions, and a semiconductor package with high reliability can be achieved even when it is exposed to severe reflow conditions. If the content of the curing accelerator (c) is too small, the effect of using the curing accelerator (c) cannot be sufficiently obtained, and if the content of the curing accelerator (c) is excessive, the curing accelerator (c) with high polarity migrates to the adhesion interface side with the adherend in the film-like adhesive under high temperature and high humidity conditions and segregates, thereby lowering the reliability of the semiconductor package.

### (Filler (d))

By ensuring that the film-like adhesive further contains the filler (d), it becomes easy to adjust the coefficient of thermal expansion thereof, and the reliability of the semiconductor package can be improved by optimizing the coefficient of thermal expansion of the film-like adhesive after curing with respect to a semiconductor chip, a metal or an organic substrate.

In addition, by further containing the filler (d) in the adhesive composition, it is also possible to reduce the moisture absorption rate of the film-like adhesive after curing.

The filler (d) is preferably an inorganic filler, and preferred examples of the inorganic filler include powders of silica, alumina, talc, calcium carbonate, titanium white, red oxide, silicon carbide, boron nitride and the like; spherical beads of these silica and the like; single crystal fibers of these silica and the like; glass fibers and the like.

Among these, the filler (d) is preferably spherical silica, a silica filler or an alumina filler.

One type of the filler (d) may be used alone, or two or more types thereof may be used in combination.

In the case of using the filler (d), the proportion of the content of the filler (d) with respect to the total content of the solid content of the adhesive composition (the content of the filler (d) of the film-like adhesive) is preferably from 5 to 80% by mass, more preferably from 7 to 60% by mass, still more preferably from 7 to 40% by mass, and particularly preferably from 8 to 20% by mass. When the content of the filler (d) is in such a range, it becomes easier to obtain the effect of adjusting the coefficient of thermal expansion described above.

### (Coupling agent (e))

By using a coupling agent (e) having a functional group that reacts with an inorganic compound and a functional group that reacts with an organic functional group, it is possible to improve the adhesive properties and adhesion of the film-like adhesive to an adherend. Further, by using the coupling agent (e), water resistance can be improved for the cured product obtained by curing the film-like adhesive without impairing its heat resistance.

The coupling agent (e) is preferably a compound having a functional group that reacts with a functional group included in the polymer component (a), the epoxy-based thermosetting resin (b) and the like, and a silane coupling agent is desirable.

Preferable examples of the silane coupling agent include 3-glycidoxypropyltrimethoxysilane, 3-glycidoxypropyltriethoxysilane, 3-glycidoxypropylmethyldiethoxysilane, 2-(3,4-epoxycyclohexyl) ethyltrimethoxysilane, 3- (methacryloyloxypropyl) trimethoxysilane, 3-aminopropyltrimethoxysilane, 3-anilinopropyltrimethoxysilane, N-6-(aminoethyl)-3-aminopropyltrimethoxysilane, N-6-(aminoethyl)-3-aminopropylmethyldiethoxysilane, N-phenyl-3-aminopropyltrimethoxysilane, 3-ureidopropyltriethoxysilane, 3-mercaptopropyltrimethoxysilane, 3-mercaptopropyl methyldimethoxysilane, bis(3-triethoxysilylpropyl) tetrasulfane, methyltrimethoxysilane, methyltriethoxysilane, vinyltrimethoxysilane, vinyltriacetoxysilane, imidazole silane, and the like.

One type of the coupling agent (e) may be used alone, or two or more types thereof may be used in combination.

When the film-like adhesive contains the polymer component (a), the epoxy-based thermosetting resin (b) and the coupling agent (e), the proportion of the content of the coupling agent (e) in the adhesive composition (the adhesive) is preferably from 0.03 to 20 parts by mass, more preferably from 0.05 to 10 parts by mass, and particularly preferably from 0.1 to 5 parts by mass, with respect to 100 parts by mass of the total content of the polymer component (a) and the epoxy-based thermosetting resin (b). If the content of the coupling agent (e) is too small, the above-mentioned effect due to the use of the coupling agent (e) sometimes cannot be obtained, and if the content of the coupling agent (e) is too large, outgas may be generated.

### (Crosslinking agent (f))

When a polymer component (a) having a functional group capable of bonding with another compound such as an isocyanate group is used, it is possible to use a crosslinking agent (f) for crosslinking this functional group by bonding with another compound. By performing the crosslinking process using the crosslinking agent (f), the initial adhesive force and cohesive force of the film-like adhesive can be controlled.

Examples of the crosslinking agent (f) include an organic polyvalent isocyanate compound and an organic polyvalent imine compound.

Examples of the organic polyvalent isocyanate compound include an aromatic polyvalent isocyanate compound, an aliphatic polyvalent isocyanate compound, an alicyclic polyvalent isocyanate compound, a trimer, isocyanurate compound and adduct of these compounds (a reaction product with a low molecular weight active hydrogencontaining compound, such as ethylene glycol, propylene glycol, neopentyl glycol, trimethylolpropane or castor oil, for example, trimethylolpropane adduct xylylene diisocyanate or the like), an isocyanate-terminated polyurethane prepolymer obtained by reacting an organic polyvalent isocyanate compound with a polyol compound and the like.

Specific examples of the organic polyvalent isocyanate compound include 2,4-tolylene diisocyanate; 2,6-tolylene diisocyanate; 1,3-xylylene diisocyanate; 1,4-xylene diisocyanate; diphenylmethane-4,4'-diisocyanate; diphenylmethane-2,4'-diisocyanate; 3-methyldiphenylmethane diisocyanate; hexamethylene diisocyanate; isophorone diisocyanate; dicyclohexylmethane-4,4'-diisocyanate; dicyclohexylmethane-2,4'-diisocyanate; a compound obtained by adding one or both of tolylene diisocyanate and hexamethylene diisocyanate to all or a part of the hydroxyl groups of a polyol such as trimethylolpropane; and lysine diisocyanate.

Examples of the organic polyvalent imine compound include N,N'-diphenylmethane-4,4'-bis(1-aziridinecarboxamide), trimethylolpropane-tri-β-aziridinyl propionate, tetramethylolmethane-tri-β-aziridinyl propionate and N,N'-toluene-2,4-bis(1-aziridinecarboxamide)triethylene melamine.

When an isocyanate-based crosslinking agent is used as the crosslinking agent (f), it is preferable to use a hydroxyl group-containing polymer as the polymer component (a). In the case where the crosslinking agent (f) has an isocyanate group and the polymer component (a) has a hydroxyl group, a crosslinked structure can be easily introduced into the film-like adhesive by the reaction of the crosslinking agent (f) and the polymer component (a).

When the crosslinking agent (f) is used, the proportion of the content of the crosslinking agent (f) in the adhesive composition (the film-like adhesive) is preferably from 0.01 to 20 parts by mass, more preferably from 0.1 to 10 parts by mass, and particularly preferably from 0.5 to 5 parts by mass, with respect to 100 parts by mass of the content of the polymer component (a).

### (Other thermosetting resin (g))

Any other thermosetting resin (g) may be used as long as it does not correspond to an epoxy resin, and examples thereof include a thermosetting polyimide resin, a polyurethane resin, an unsaturated polyester resin and a silicone resin.

### (Energy ray-curable resin (h))

The energy ray-curable resin (h) may be used in order to change the properties of the film-like adhesive by irradiation of energy rays. The energy ray-curable resin contains an energy ray-polymerizable group and is polymerized and cured when irradiated with energy rays such as ultraviolet rays and electron beams. Specific examples of such energy ray-polymerizable compounds include (meth)acrylate-based compounds such as trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate or 1,4-butylene glycol di(meth)acrylate, 1,6-hexanediol di(meth)acrylate, polyethylene glycol di(meth)acrylate, oligoester (meth)acrylate, urethane (meth)acrylate-based oligomers, epoxy-modified (meth)acrylates, polyether (meth)acrylates and itaconic acid oligomers. Such a compound has at least one polymerizable double bond in the molecule, and the weight average molecular weight thereof is preferably from 100 to 30,000, and more preferably from about 300 to 10,000.

One type of the energy ray-curable resin (h) may be used alone, or two or more types thereof may be used in combination.

### (Photopolymerization initiator (i))

In order to efficiently carry out the polymerization reaction of the energy ray-curable resin (h), the photopolymerization initiator (i) can be used. Specific examples of such a photopolymerization initiator (i) include benzophenone, acetophenone, benzoin, benzoin methyl ether, benzoin ethyl ether, benzoin isopropyl ether, benzoin isobutyl ether, benzoin benzoic acid, benzoin methyl benzoate, benzoin dimethyl ketal, 2,4-diethylthioxanthone, α-hydroxycyclohexyl phenyl ketone, benzyl diphenyl sulfide, tetramethylthiuram monosulfide, azobisisobutyronitrile, benzyl, dibenzyl, diacetyl, 1,2-diphenylmethane, 2-hydroxy-2-methyl-1-[4-(1-methylvinyl)phenyl]propanone, 2,4,6-trimethylbenzoyldiphenylphosphine oxide and β-chloroanthraquinone.

One type of the photopolymerization initiator (i) may be used alone, or two or more types thereof may be used in combination.

### (General purpose additive (j))

Examples of the general purpose additive (j) include known plasticizers, antistatic agents, antioxidants, pigments, dyes, gettering agents and the like.

### (Solvent)

By further containing a solvent, the handling properties of the adhesive composition are improved by dilution.

Although the solvent contained in the adhesive composition is not particularly limited, preferred examples thereof include hydrocarbons such as toluene and xylene; alcohols such as methanol, ethanol, 2-propanol, isobutyl alcohol (2-methylpropan-1-ol) and 1-butanol; esters such as ethyl acetate; ketones such as acetone and methyl ethyl ketone; ketones such as acetone and methyl ethyl ketone; ethers such as tetrahydrofuran; and amides such as dimethylformamide and N-methylpyrrolidone (compounds having an amide bond).

The adhesive composition may contain only one type of solvent or two or more types of solvents.

The solvent contained in the adhesive composition is preferably methyl ethyl ketone or the like from the viewpoint of uniformly mixing the components used in the adhesive composition.

The adhesive composition can be obtained by blending the above-mentioned components for constituting the film-like adhesive, such as the polymer component (a) and the epoxy-based thermosetting resin (b).

The addition order at the time of blending each component is not particularly limited, and two or more types of components may be added at the same time.

In the case of using a solvent, it may be used by mixing the solvent with any one of the blended components other than the solvent and diluting the blended component in advance, or it may be used by mixing the solvent with these blended components without previously diluting any of the blended components other than the solvent.

The method of mixing the components at the time of blending is not particularly limited, and may be selected appropriately from known methods, such as a method of mixing by rotating a stirrer, a stirring blade or the like; a method of mixing with a mixer; and a method of mixing by applying ultrasonic waves.

The temperature and time at the time of adding and mixing each component are not particularly limited, as long as each blended component does not deteriorate, and may be adjusted appropriately, although the temperature is preferably from 15 to 30°C.

In the film-like adhesive according to an embodiment of the present invention, a preferable combination of the polymer component (a), the epoxy resin (b1), the thermal curing agent (b2), the curing accelerator (c), the filler (d) and the coupling agent (e) is such that the polymer component (a) is an acrylic resin, the epoxy resin (b1 is a bisphenol A type epoxy resin and a polyfunctional aromatic epoxy resin, the thermal curing agent (b2) is a biphenyl aralkyl type phenolic resin, the curing accelerator (c) is an imidazole, the filler (d) is a powder of silica and the coupling agent (e) is a silane coupling agent.

In the film-like adhesive composite sheet, it is preferable that the support sheet is composed of the base material and the film-like adhesive is provided on and in direct contact with the base material. As described above, when the support sheet does not have the pressure-sensitive adhesive layer and the film-like adhesive is directly provided on the base material, interlayer movement of constituents (for example, migration of the components in the film-like adhesive to the pressure-sensitive adhesive layer, or, conversely, migration of the components in the pressure-sensitive adhesive layer to the film-like adhesive) is suppressed, and the occurrence of process abnormality at the time of manufacturing the semiconductor device and deterioration of the reliability of the semiconductor package are highly suppressed.

Normally, when a film-like adhesive composite sheet having no pressure-sensitive adhesive layer is used, a doubled die is easily generated when the semiconductor chip is separated from the support sheet while the film-like adhesive is adhered thereto. However, if the film-like adhesive composite sheet according to the present invention is used, the occurrence of doubled dies is suppressed even when this composite sheet does not have a pressure-sensitive adhesive layer.

### <Method for producing film-like adhesive composite sheet>

The film-like adhesive composite sheet can be produced by forming a film-like adhesive on the support sheet.

In the case where the support sheet is the base material, the film-like adhesive may be formed on the base material in the same manner as in the case of forming the pressure-sensitive adhesive layer on the base material as described above, except that the adhesive composition is used instead of the pressure-sensitive adhesive composition.

In the case where the support sheet is provided with a pressure-sensitive adhesive layer on the base material, it is usually difficult to directly apply the adhesive composition onto the pressure-sensitive adhesive layer. Accordingly, in this case, it is preferable to form a film-like adhesive on the base material by a method of separately forming the film-like adhesive in advance and pasting the film-like adhesive onto the surface of the pressure-sensitive adhesive layer (for example, the adhesive composition is applied onto the surface of a release layer of a release material and dried to thereby form a film-like adhesive, and the exposed surface on the side of the film-like adhesive where no release material has been provided is adhered onto the surface of the pressure-sensitive adhesive layer, followed by removal of the release material).

Further, in addition to the above-mentioned method, the film-like adhesive composite sheet having a pressure-sensitive adhesive layer can also be produced, for example, by forming a pressure-sensitive adhesive layer using a pressure-sensitive adhesive composition and forming a film-like adhesive using an adhesive composition, and then pasting together the pressure-sensitive adhesive layer and the film-like adhesive to form a laminated body, and adhering the base material to the surface of the pressure-sensitive adhesive layer of the laminated body.

In this case, the conditions for forming the pressure-sensitive adhesive layer and the film-like adhesive are the same as those described above.

### <<Method for manufacturing semiconductor device>>

A method of manufacturing a semiconductor device according to the present invention is a method for manufacturing a semiconductor device using the film-like adhesive composite sheet, and characterized by including: a step of adhering the film-like adhesive composite sheet to a plurality of already divided semiconductor chips via a film-like adhesive (hereinafter, sometimes abbreviated as "adhering step"); a step of applying a force to a support sheet of the film-like adhesive composite sheet adhered to the semiconductor chip from a side opposite to the side provided with the film-like adhesive, thereby applying a force to the film-like adhesive through the support sheet to cut the film-like adhesive (hereinafter, sometimes abbreviated as "cutting step"); and a step of separating the semiconductor chip and the film-like adhesive adhered thereon, after cutting, from the support sheet (hereinafter, sometimes abbreviated as "separating step").

The above manufacturing method is a so-called pre-dicing method having a step of adhering a film-like adhesive to a plurality of semiconductor chips that have been already divided in advance by dicing, and then cutting the film-like adhesive. According to the above manufacturing method, by using the film-like adhesive composite sheet, it is possible to reliably separate the semiconductor chip to which the film-like adhesive is adhered from the support sheet without any process abnormality by a simplified method at the time of manufacturing the semiconductor device.

### <Adhering step>

In the adhering step, the film-like adhesive composite sheet is adhered to a plurality of already divided semiconductor chips via a film-like adhesive. In this step, a film-like adhesive of a piece of film-like adhesive composite sheet is adhered to the back surfaces of a plurality of semiconductor chips.

The plurality of already divided semiconductor chips can be produced, for example, by forming a groove from the surface of a semiconductor wafer on the side opposite to the adhered surface (back surface) of the film-like adhesive composite sheet, and grinding the back surface until reaching the groove. Further, the plurality of already divided semiconductor chips can also be produced by providing a modified region by laser irradiation on the aforementioned surface of the semiconductor wafer or in the vicinity thereof, grinding the aforementioned back surface, and breaking the wafer at the modified region by the impact at the time of the grinding.

### <Cutting step>

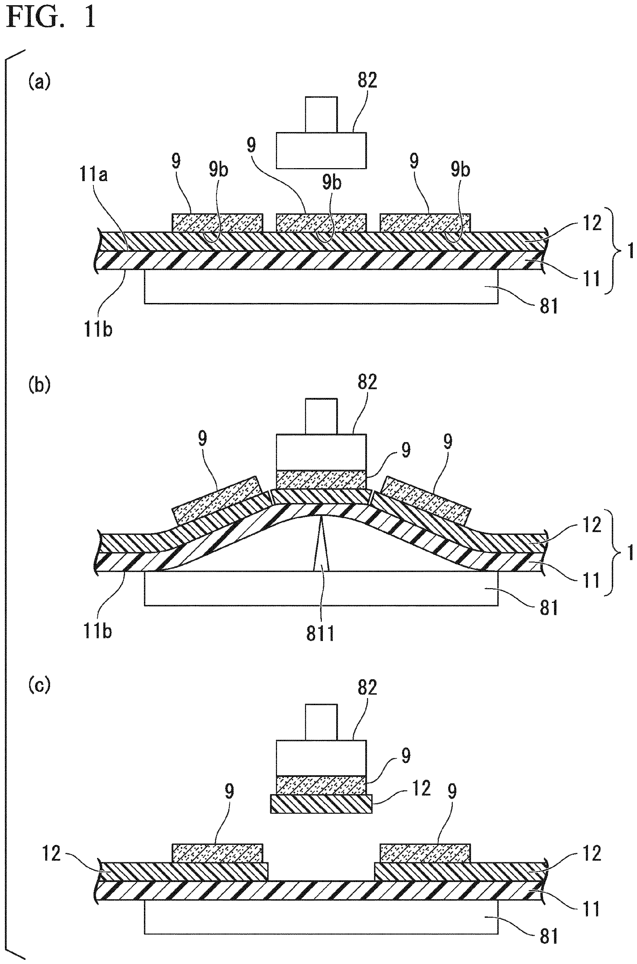

In the cutting step, after the adhering step, a force is applied to the support sheet of the film-like adhesive composite sheet adhered to the semiconductor chip from the side opposite to the side provided with the film-like adhesive, thereby applying a force to the film-like adhesive through the support sheet and cutting the film-like adhesive. Hereinafter, the manufacturing method according to the present invention will be described with reference to the drawings. FIG. 1 is a cross-sectional view schematically illustrating one embodiment from cutting of a film-like adhesive to separation of a semiconductor chip from a support sheet in the manufacturing method according to the present invention. In FIG. 1, only the configuration related to the film-like adhesive composite sheet is shown in cross section.

As shown in FIG. 1 (a), a film-like adhesive 12 of a film-like adhesive composite sheet 1 is adhered to back surfaces 9b of a plurality of semiconductor chips 9 due to the adhering step. Further, in this step, among the apparatus for manufacturing a semiconductor device (illustration of the overall view is omitted), a thrust portion 81 for pushing up the semiconductor chip abuts against a surface (back surface) 11b of a support sheet 11 in the film-like adhesive composite sheet 1 opposite to a surface (front surface) 11a provided with the film-like adhesive 12.

In this step, subsequently, as shown in FIG. 1 (b), a force is applied to the support sheet 11 of the film-like adhesive composite sheet 1 from the back surface 11b thereof in the thickness direction of the support sheet, thereby applying a force to the film-like adhesive 12 through the support sheet 11. Here, an example is shown in which a protrusion (pin) 811 protrudes from the thrust portion 81 and a tip portion of the protrusion 811 pushes up the support sheet 11 from its back surface 11b, thereby applying a force to the film-like adhesive 12 through the support sheet 11 in the protrusion direction of the protrusion 811. At this time, it is possible to appropriately adjust the thrusting conditions such as the protrusion amount (push-up amount) of the protrusion 811, the protrusion rate (push-up rate) and the retention time of the protrusion state (lifting latency). The push-up amount may be 1 to 1,000 µm, 10 to 100 µm, or 30 to 70 µm. The push-up rate may be 0.1 to 50 mm/sec, or may be 0.5 to 20 mm/sec. The lifting latency may be 1 to 1,000 milliseconds, 10 to 100 milliseconds, or 20 to 50 milliseconds.

Here, although a case where the number of the protrusions 811 that push up the support sheet 11 is one is shown, it may be two or more, and the number of the protrusions 811 may be appropriately selected. It should be noted that as a method of applying a force to the film-like adhesive 12 through the support sheet 11, for example, other known methods such as a method of applying a force by pushing up with a slider can also be appropriately employed.

As described above, when a force is applied to the film-like adhesive 12, since the film-like adhesive composite sheet 1 is used, due to the shearing force generated as the protrusion 811 is pushed up, the film-like adhesive 12 is cut at an intended portion (a portion surrounding only the object to be separated, as the semiconductor chip 9, from the support sheet 11).

### <Separating step>

In the separating step, after the cutting step, as shown in FIG. 1 (c), the semiconductor chip 9 and the cut film-like adhesive 12 adhered thereto are separated (picked up) from the support sheet 11. This step (separating step) is usually carried out continuously immediately after the cutting step. Here, an example is shown in which the semiconductor chip 9 is pulled up by a lifting portion 82 of the manufacturing apparatus of a semiconductor device, so that the cut film-like adhesive 12 adhered to the semiconductor chip 9 is separated from the support sheet 11. As described above, the method of pulling up the semiconductor chip 9 may be a known method, and more specifically, a method of sucking and pulling up the surface of the semiconductor chip 9 with a vacuum collet or the like can be exemplified.

As described above, when the semiconductor chip 9 is lifted, since the film-like adhesive composite sheet 1 is used, the film-like adhesive 12 is reliably separated from the support sheet 11. Further, since the film-like adhesive 12 is cut at a predetermined portion, the lifted semiconductor chip 9 is separated from the support sheet 11 together with the film-like adhesive 12.

In the manufacturing method according to the present invention, the semiconductor device is manufactured by using the semiconductor chip separated (picked up) together with the film-like adhesive, and thereafter using the same method as the conventional method. For example, the semiconductor chip is die bonded to the circuit surface of a substrate with the film-like adhesive and, if necessary, on the semiconductor chip, one or more semiconductor chips are further stacked, and after carrying out wire bonding, they are sealed as a whole by a resin, thereby forming a semiconductor package. Then, it is possible to place this semiconductor package on a substrate to manufacture a desired semiconductor device.

When the film-like adhesive composite sheet according to the present invention is not used, the following process abnormality may occur at the time of manufacturing the semiconductor device.

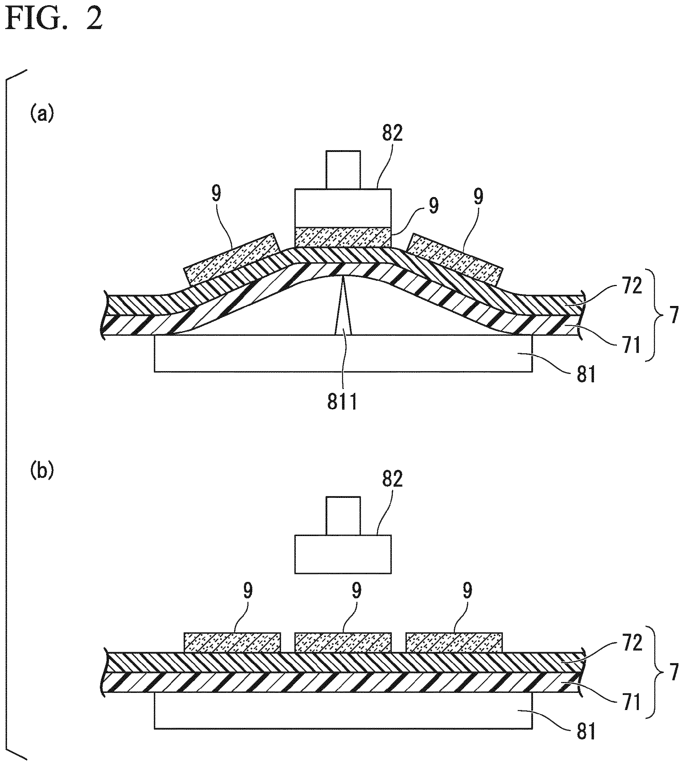

FIG. 2 is a cross-sectional view schematically illustrating one aspect of a film-like adhesive composite sheet and a semiconductor chip in a manufacturing process of a semiconductor device when a conventional film-like adhesive composite sheet is used.

In a film-like adhesive composite sheet 7 shown here, the breaking elongation of a film-like adhesive 72 before curing is larger than that in the case of the present invention and the peel force at the interface between a support sheet 71 and the film-like adhesive 72 is larger than that in the case of the present invention. Typically, when this type of film-like adhesive composite sheet 7 is used, as shown in FIG. 2 (a), even if a force is applied to the film-like adhesive 72, the film-like adhesive 72 is not cut, and even if it is attempted to pull up the semiconductor chip 9, the film-like adhesive 72 does not peel off from the support sheet 71. As a result, as shown in FIG. 2 (b), a lifting failure of the semiconductor chip 9 occurs.

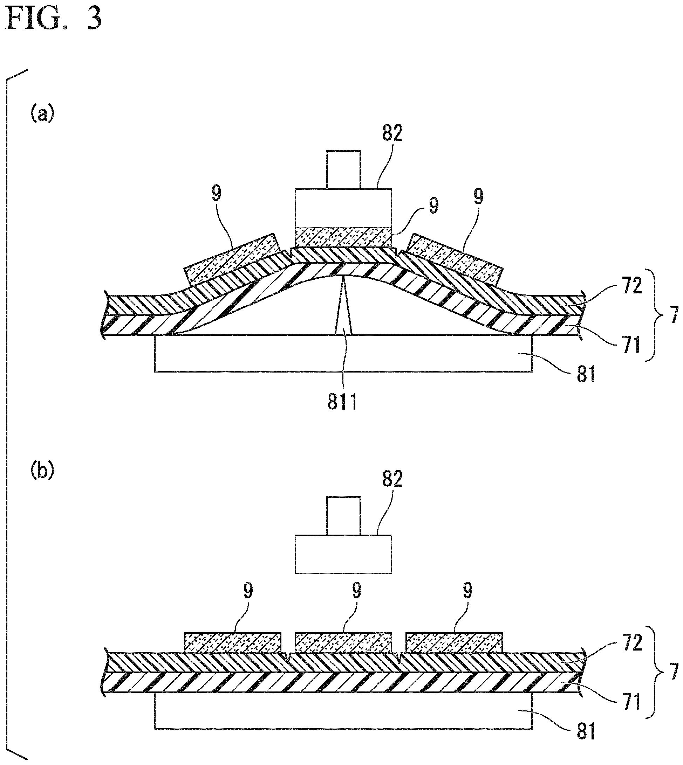

FIG. 3 is a cross-sectional view schematically illustrating another aspect of a film-like adhesive composite sheet and a semiconductor chip in a manufacturing process of a semiconductor device when a conventional film-like adhesive composite sheet is used.

In the film-like adhesive composite sheet 7 shown here, the breaking elongation of the film-like adhesive 72 before curing is the same as that in the case of the present invention and the peel force at the interface between the support sheet 71 and the film-like adhesive 72 is larger than that in the case of the present invention. When this type of film-like adhesive composite sheet 7 is used, even if a force is applied to the film-like adhesive 72, the film-like adhesive 72 is not necessarily reliably cut, and for example, as shown in FIG. 3 (a), only a notch is formed in a part of the film-like adhesive 72 in some cases. Further, even if the film-like adhesive 72 is cut, there is a possibility that it is not cut at an intended position so as to have the same shape as that of the semiconductor chip 9. In addition, regardless of whether or not the film-like adhesive 72 is cut, even if it is attempted to pull up the semiconductor chip 9, the film-like adhesive 72 does not peel off from the support sheet 71.

As a result, for example, as shown in FIG. 3 (b), a lifting failure of the semiconductor chip 9 occurs. FIG. 3 (b) shows a case where only a notch is formed in a part of the film-like adhesive 72.

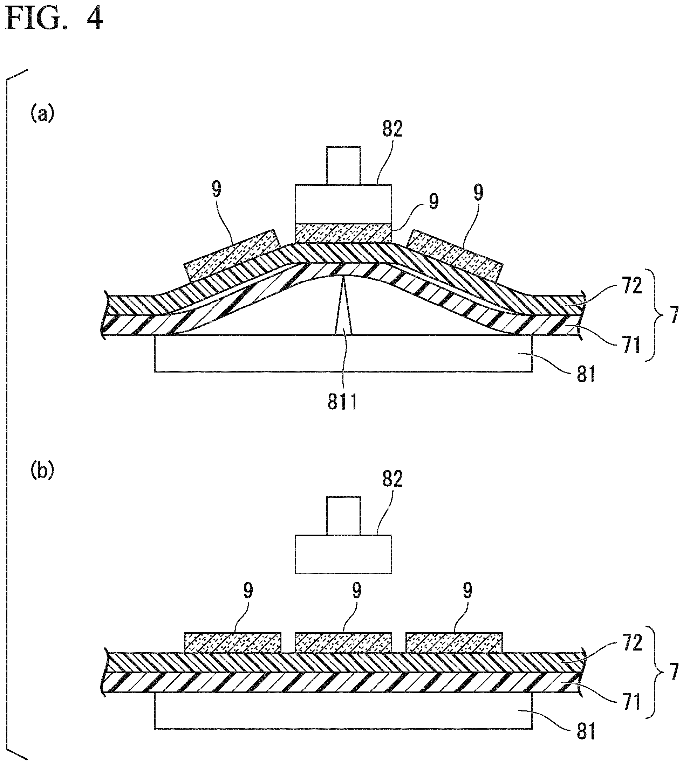

FIG. 4 is a cross-sectional view schematically illustrating yet another aspect of a film-like adhesive composite sheet and a semiconductor chip in a manufacturing process of a semiconductor device when a conventional film-like adhesive composite sheet is used.

In the film-like adhesive composite sheet 7 shown here, the breaking elongation of the film-like adhesive 72 before curing is larger than that in the case of the present invention, and the peel force at the interface between the support sheet 71 and the film-like adhesive 72 is the same as that in the case of the present invention, or it is smaller than that in the case of the present invention. Typically, when this type of film-like adhesive composite sheet 7 is used, even if a force is applied to the film-like adhesive 72, the film-like adhesive 72 is not cut. Further, by pulling up the semiconductor chip 9, as shown in FIG. 4 (a), the film-like adhesive 72 is peeled off from the support sheet 71 not only at a portion corresponding to the semiconductor chip 9 being pulled up but also at a portion corresponding to the semiconductor chip 9 adjacent thereto. As a result, the intended semiconductor chip 9 cannot be pulled up, and as shown in FIG. 4 (b), a lifting failure of the semiconductor chip 9 occurs.

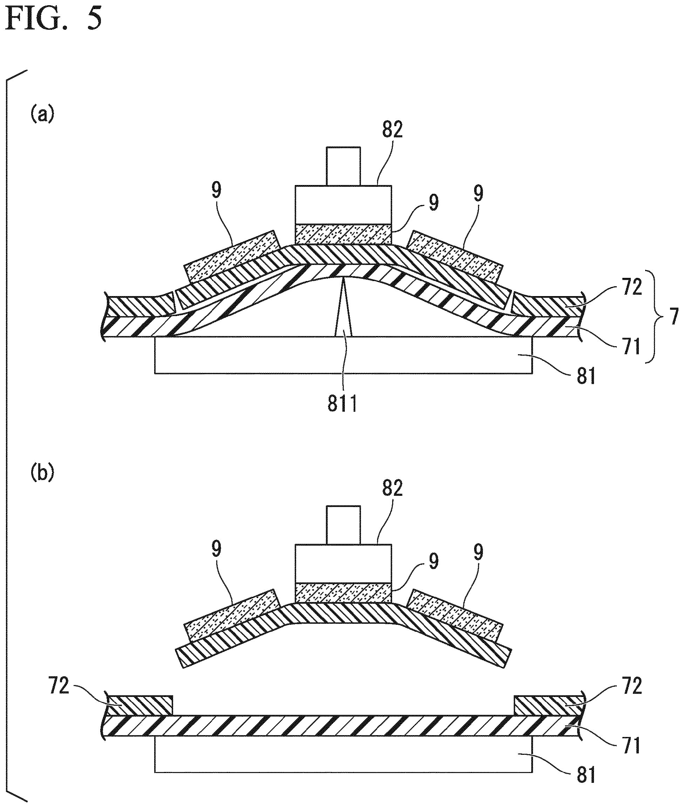

FIG. 5 is a cross-sectional view schematically illustrating yet another aspect of a film-like adhesive composite sheet and a semiconductor chip in a manufacturing process of a semiconductor device when a conventional film-like adhesive composite sheet is used.

In the film-like adhesive composite sheet 7 shown here, the breaking elongation of the film-like adhesive 72 before curing is the same as that in the case of the present invention, and the peel force at the interface between the support sheet 71 and the film-like adhesive 72 is the same as that in the case of the present invention or is smaller than that in the case of the present invention. Typically, when this type of film-like adhesive composite sheet 7 is used, as shown in FIG. 5 (a), by applying a force to the film-like adhesive 72, the film-like adhesive 72 is cut so that the intended semiconductor chip 9 and the adjacent semiconductor chip 9 are integrated with each other, and by pulling up the semiconductor chip 9, these semiconductor chips 9 are peeled off and pulled apart from the support sheet 11 together with the film-like adhesive 72. As a result, a doubled die occurs as shown in FIG. 5 (b).

It should be noted that, here, for the sake of simplicity, a case where the number of the semiconductor chips 9 separated from the support sheet 71 is three is shown, but the number of the semiconductor chips 9 separated from the support sheet 71 may be other numbers such as four or more.

It should be noted that the process abnormality described with reference to FIGS. 2 to 5 is typical, and in some cases, other process abnormality may occur.

On the other hand, in the case of using the film-like adhesive composite sheet according to the present invention, the occurrence of such process abnormality is suppressed, and as a result, the semiconductor device can be manufactured inexpensively by a more simplified method than the conventional method.

### Examples

Hereinafter, the present invention will be described in more detail with reference to specific examples. However, the present invention is not limited in any way by the following examples.

### <Production of support sheet>

### [Production Example 1]

### (Production of acrylic polymer)

80 parts by mass of lauryl acrylate (hereinafter abbreviated as "LA") and 20 parts by mass of 2-hydroxyethyl acrylate (hereinafter abbreviated as "HEA") were used as raw material monomers to carry out a polymerization reaction, thereby obtaining an acrylic polymer (A).

To this acrylic polymer (A), 2-methacryloyloxyethyl isocyanate (hereinafter abbreviated as "MOI") (22 parts by mass, about 80 mol% with respect to HEA) and dibutyltin laurylate (hereinafter abbreviated as "DBTL") (0.13 parts by mass) were added to carry out an addition reaction, thereby obtaining an intended acrylic polymer.

The blending ratio of each component is shown in Table 1. It should be noted that in Table 1, the symbol "-" means that the component is not blended.

### (Production of pressure-sensitive adhesive composition)

After adding a photopolymerization initiator ("IRGACURE 651", benzyl dimethyl ketal, manufactured by Ciba Specialty Chemicals Inc.) (3 parts by mass) and acetylacetone (1 part by mass) as a reaction retarder to the acrylic polymer (100 parts by mass) obtained above, the resulting mixture was diluted with methyl ethyl ketone and then thoroughly stirred, and a tolylene diisocyanate trimer adduct of trimethylolpropane ("CORONATE L" manufactured by Nippon Polyurethane Industry Co., Ltd.) (7.5 parts by mass, in an amount such that the amount of the isocyanate group contained is 1 mole with respect to 1 mole of the residual hydroxyl group in the acrylic polymer) was further added thereto as an isocyanate-based crosslinking agent and stirred at 23°C, thereby obtaining a pressure-sensitive adhesive composition having a solid content concentration of 25% by mass.

The blending ratio of each component is shown in Table 1.

### (Production of support sheet)

Using a layer composed of a single layer of an ethylene-methacrylic acid copolymer ("EANU80-AL-ND" manufactured by Achilles Corporation, thickness: 80 µm) as a base material, the base material was subjected to a corona irradiation treatment. Subsequently, the pressure-sensitive adhesive composition obtained above was applied to a release film (SP-PET 381031, manufactured by Lintec Corporation) and dried by heating at 120°C for 1 minute to form a pressure-sensitive adhesive layer having a thickness of 10 µm. This pressure-sensitive adhesive layer was adhered to the corona irradiation-treated surface of the above-mentioned base material to obtain a support sheet having the pressure-sensitive adhesive layer and the release film on the base material.

### <Production of support sheet>

### [Production Example 2]

### (Production of acrylic polymer)

2-ethylhexyl acrylate (hereinafter abbreviated as "2EHA") (60 parts by mass), methyl methacrylate (hereinafter abbreviated as "MMA") (30 parts by mass) and HEA (10 parts by mass) were used as raw material monomers to carry out a polymerization reaction, thereby obtaining an acrylic polymer.

The blending ratio of each component is shown in Table 1.

### (Production of pressure-sensitive adhesive composition)

An isocyanate-based crosslinking agent ("BHS 8515" manufactured by Toyochem Co., Ltd., tolylene diisocyanate adduct of trimethylolpropane) (16 parts by mass) was added to this acrylic polymer (84 parts by mass), and the resulting mixture was diluted with methyl ethyl ketone and then thoroughly stirred to obtain a pressure-sensitive adhesive composition.

The blending ratio of each component is shown in Table 1.

### (Production of support sheet)

Using a layer composed of a single layer of an ethylene-methacrylic acid copolymer ("EANU80-AL-ND" manufactured by Achilles Corporation, thickness: 80 µm) as a base material, the base material was subjected to a corona discharge treatment. Subsequently, the pressure-sensitive adhesive composition obtained above was applied to a release film (SP-PET 381031, manufactured by Lintec Corporation) and dried by heating at 120°C for 1 minute to form a pressure-sensitive adhesive layer having a thickness of 10 µm. This pressure-sensitive adhesive layer was adhered to the corona irradiation-treated surface of the above-mentioned base material to obtain a support sheet having the pressure-sensitive adhesive layer and the release film on the base material.

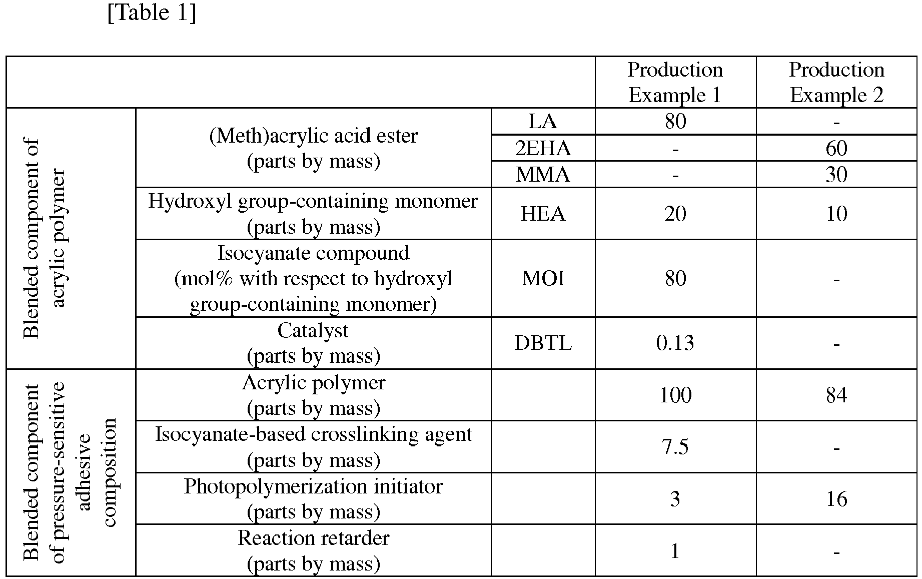

### <Production of film-like adhesive composite sheet>

### [Examples 1 to 4, Comparative Examples 1 to 4]

### (Production of adhesive composition)

Each component was blended in the amounts shown in Tables 2 and 3, and further diluted with methyl ethyl ketone so that the solid content concentration was 50% by mass, thereby obtaining an adhesive composition.

It should be noted that the abbreviations for the respective components in Tables 2 and 3 respectively have the following meanings. In addition, the symbol "-" means that the component is not blended.

### - Polymer component (a)

(a)-1: Acrylic resin ("COPONYL N-2359-6" manufactured by The Nippon Synthetic Chemical Industry Co., Ltd.)
(a)-2: thermoplastic resin, polyester ("Byron 220" manufactured by Toyobo Co., Ltd.)

### - Epoxy resin (b1)

(b1)-1: Bisphenol A type epoxy resin ("Epikote 834" manufactured by Japan Epoxy Resin Co., Ltd., molecular weight: 470, semisolid epoxy resin)
(b1)-2: Polyfunctional aromatic epoxy resin ("EPPN-502H" manufactured by Nippon Kayaku Co., Ltd., solid epoxy resin having a softening point of 60 to 72°C)
(b1)-3: Bisphenol A type epoxy resin obtained by uniformly dispersing acrylic rubber fine particles ("BPA 328" manufactured by Nippon Shokubai Co., Ltd., epoxy equivalent: 230 ± 10 g/eq, acrylic rubber content: 20 ± 1 phr, liquid epoxy resin)
(b1)-4: Epoxy resin into which a flexible skeleton is introduced ("EXA 4850-150" manufactured by DIC Corporation, molecular weight: 900, liquid epoxy resin)
(b1)-5: Bisphenol A type epoxy resin ("Epikote 1055" manufactured by Japan Epoxy Resin Co., Ltd., solid epoxy resin having a molecular weight of 1,600 and a softening point of 93°C)

### - Thermal curing agent (b2)

(b2)-1: Biphenyl aralkyl type phenolic resin ("MEH-7851-SS" manufactured by Meiwa Plastic Industries, Ltd., softening point: 67°C)
(b2)-2: Novolac-type phenolic resin ("BRG-556" manufactured by Showa Denko K.K., softening point: 80°C)
(b2)-3: Biphenyl aralkyl type phenolic resin ("MEH-7851-H" manufactured by Meiwa Plastic Industries, Ltd., softening point: 83°C)

### - Curing accelerator (c)

(c)-1: 2-phenyl-4,5-dihydroxymethylimidazole ("Curezol 2PHZ" manufactured by Shikoku Chemicals Corporation)

### - Filler (d)

(d)-1: Spherical silica ("SC 2050" manufactured by Admatechs Co., Ltd.)
(d)-2: Spherical silica ("SC 2050 MA" manufactured by Admatechs Co., Ltd.)

### - Coupling agent (e)

(e)-1: Silane coupling agent, 3-glycidoxypropyltrimethoxysilane ("KBM-403" manufactured by Shin-Etsu Silicone Co., Ltd.)
(e)-2: Silane coupling agent, 3-glycidoxypropyltriethoxysilane ("KBE-403" manufactured by Shin-Etsu Silicone Co., Ltd.)
(e)-3: Silicone oligomer containing silane coupling agent, epoxy group, methyl group and methoxy group ("X-41-1056" manufactured by Shin-Etsu Silicone Co., Ltd., epoxy equivalent: 280 g/mol)
(e)-4: Silane coupling agent ("MKC Silicate MSEP 2" manufactured by Mitsubishi Chemical Corporation)
(e)-5: Silane coupling agent, 3-anilinopropyltrimethoxysilane ("SZ-6083" manufactured by Dow Corning Toray Silicone Co., Ltd.)

### - Other components (z)

(h)-1: Ultraviolet-curable resin, tricyclodecanedimethylol diacrylate ("KAYARAD R-684" manufactured by Nippon Kayaku Co., Ltd.)
(i)-1: Photoinitiator, 1-hydroxycyclohexyl phenyl ketone ("Irgacure 184" manufactured by Ciba Specialty Chemicals Inc.)

### (Production of film-like adhesive composite sheet)

Using a release film (SP-P502010, manufactured by Lintec Corporation, thickness: 50 µm) in which one side of a polyethylene terephthalate film was subjected to a release treatment, the adhesive composition obtained above was applied to the release-treated surface of the release film, and dried at 100°C for 3 minutes using an oven to form a film-like adhesive having a thickness of 7 µm.

On the other hand, a base material in which: a layer composed of a low density polyethylene ("Novatec LC 520" manufactured by Japan Polyethylene Corporation, density: 0.923 g/cm³, MFR: 3.6 g/ 10 min, thickness: 8 µm); a layer containing a polypropylene (a layer composed of a mixture of a homopolypropylene resin ("Prime Polypro F-300 SP" manufactured by Prime Polymer Co., Ltd., density: 0.90 g/cm³, MFR: 3.0 g/ 10 min) and a styrene/ethylenebutylene/styrene block copolymer ("Dynaron 8601 P" manufactured by JSR Corporation, density: 0.89 g/cm³, MFR: 3.5 g/ 10 min), thickness: 60 µm); and a layer composed of a low density polyethylene (the same layer as described above except that the thickness was not 8 µm but 12 µm), were laminated in this order (hereinafter this base material may be abbreviated as "laminated base material (1)") was prepared as a support sheet. It should be noted that the above melt flow rates (MFR) are values measured in accordance with JIS K 7210 = 1999 at a measurement temperature of 190°C in the case of the low density polyethylene, 230°C in the case of the homopolypropylene resin and 230°C in the case of the styrene/ethylene butylene/styrene block copolymer, with a load of 21.18 N.

Subsequently, the film-like adhesive obtained above was adhered to a layer composed of a low density polyethylene having a thickness of 8 µm of the support sheet, and the release film was removed, thereby obtaining a film-like adhesive composite sheet provided with a film-like adhesive on the support sheet composed of the base material (Examples 1 and 2, Comparative Examples 1 and 2).

In addition, using a base material ("HUSL 1302" manufactured by Achilles Corporation, hereinafter the base material may be abbreviated as "laminated base material (2)") obtained by laminating a layer composed of a polypropylene and a layer composed of an ethylene-methacrylic acid copolymer in this order as a support sheet, the film-like adhesive obtained above was adhered to the layer composed of a polypropylene of the support sheet and the release film was removed, thereby obtaining a film-like adhesive composite sheet provided with a film-like adhesive on the support sheet composed of the base material (Comparative Example 3). It should be noted that in Comparative Example 3, the same adhesive composition as in Comparative Example 1 was used.

In addition, using one obtained by removing the release film from that obtained in Production Example 2 as a support sheet, the film-like adhesive obtained above was adhered to a pressure-sensitive adhesive layer of the support sheet and the release film was removed, thereby obtaining a film-like adhesive composite sheet in which the base material, the pressure-sensitive adhesive layer and the film-like adhesive were laminated in this order (Example 3). It should be noted that in Example 3, the same adhesive composition as in Example 1 was used.

In addition, using one obtained by removing the release film from that obtained in Production Example 1 as a support sheet, the film-like adhesive obtained above was adhered to a pressure-sensitive adhesive layer of the support sheet and the release film was removed, thereby obtaining a film-like adhesive composite sheet in which the base material, the pressure-sensitive adhesive layer and the film-like adhesive were laminated in this order (Example 4 and Comparative Example 4). It should be noted that in Example 4 and Comparative Example 4, the same adhesive composition as in Example 1 was used. As described later, in Example 4, the sample was irradiated with ultraviolet rays before the measurement and evaluation in "measurement of peel force at the interface between the support sheet and the film-like adhesive" and "evaluation of pick-up suitability".

### <Production of double-sided adhesive member for ring frame>

### [Production Example 3]

As a core material, the same as the laminated base material (1) used for manufacturing the above-mentioned film-like adhesive composite sheet was prepared.

A strong adhesion type acrylic pressure-sensitive adhesive ("PA-T1" manufactured by Lintec Corporation) was applied and dried on a release-treated surface of a light release type release film ("SP-PET 3801" manufactured by Lintec Corporation, thickness: 38 µm), and the formed pressure-sensitive adhesive layer having a thickness of 5 µm was adhered to the above-mentioned core material to obtain a single-sided pressure-sensitive adhesive tape.

100 parts by mass of an acrylic pressure-sensitive adhesive (a copolymer obtained by copolymerizing n-butyl acrylate and acrylic acid (n-butyl acrylate / acrylic acid = 90/10 (mass ratio), weight average molecular weight: 600,000, glass transition temperature: -44°C)), 200 parts by mass of a urethane acrylate oligomer having a molecular weight of 7,000, 10 parts by mass of an isocyanate-based crosslinking agent and 10 parts by mass of a benzophenone-based energy ray-curing reaction initiator were mixed to obtain an energy ray-curable pressure-sensitive adhesive composition.

The obtained energy ray-curable pressure-sensitive adhesive composition was applied to a release-treated surface of a heavy release type release film ("SP-PET 3811" manufactured by Lintec Corporation, thickness: 38 µm) and dried at 90°C for 1 minute, thereby forming an energy ray-curable pressure-sensitive adhesive layer having a thickness of 5 µm. Subsequently, this energy ray-curable pressure-sensitive adhesive layer was adhered to the core material of the above-mentioned single-sided pressure-sensitive adhesive tape to prepare a double-sided pressure-sensitive adhesive member for a ring frame as a double-sided pressure-sensitive adhesive tape having a thickness of 90 µm.

### <Evaluation of film-like adhesive composite sheet>

### (Preparation of samples for evaluation)

The double-sided pressure-sensitive adhesive member for a ring frame obtained as described above was punched into a circular shape having a diameter of 220 mm from the light release type release film up to the energy ray-curable pressure-sensitive adhesive layer while leaving only the heavy release type release film, and this circular portion was removed. Then, the light release type release film on the outer periphery of the circular portion was peeled off, and the exposed surface of the strong adhesion type acrylic pressure-sensitive adhesive was adhered to the film-like adhesive of the film-like adhesive composite sheet obtained above.

Subsequently, in order to be formed concentrically with the previously punched circular portion and to leave only the heavy release type release film, layers from the base material of the film-like adhesive composite sheet up to the energy ray-curable pressure-sensitive adhesive layer were punched into a circular shape having a diameter of 270 mm, and the outer peripheral portion thereof was removed.

As described above, a sample for evaluation was prepared in which a double-sided pressure-sensitive adhesive member for a ring frame having a width of 25 mm was provided on the outer peripheral portion of the film-like adhesive composite sheet.

### (Measurement of peel force at the interface between the support sheet and the film-like adhesive)

Using a product in which a double-sided tape is adhered on the surface of a hard support made of a polystyrene plate, the film-like adhesive of the film-like adhesive composite sheet having a size of 25 mm × 250 mm and obtained in each of the above Examples and Comparative Examples was superimposed on the double-sided tape, and a rubber roller of 2 kg was reciprocated once on this superimposed product in an environment of 23°C and relative humidity of 50% so that the film-like adhesive composite sheet was adhered to the hard support via the double-sided tape. Thereafter, ultraviolet rays were irradiated under the conditions of an illuminance of 220 mW/cm² and a light amount of 160 mJ/cm² using an ultraviolet irradiation apparatus ("Adwill RAD 2000/m12" manufactured by Lintec Corporation) with respect to the film-like adhesive composite sheet of Example 2, and under the conditions of an illuminance of 200 mW/cm² and a light amount of 160 mJ/cm² using the same ultraviolet irradiation apparatus as described above with respect to the film-like adhesive composite sheet of Example 4, respectively.

Subsequently, the resulting adhered product was allowed to stand in the same environment of 23°C and relative humidity of 50% for 30 minutes, and then the peel force (N/ 25 mm) when the base material of the film-like adhesive composite sheet was peeled off from the film-like adhesive at a speed of 300 mm/min with an angle of 180° was measured using an Autograph as a measuring device. The results are shown in the columns of "peel force" in Tables 2 and 3.

### (Measurement of breaking elongation of laminated body composed of film-like adhesive before curing)

Using a laminator, two of the film-like adhesives obtained in each of the above-mentioned Examples and Comparative Examples were adhered to each other and the same film-like adhesive was further adhered repeatedly to produce a laminated body in which the film-like adhesive was laminated so that the total thickness was 203 µm.

Then, using a hot plate heated to 80°C, the obtained laminated body was heated for 30 seconds. Thereafter, only the film-like adhesive composite sheet of Example 2 was irradiated with ultraviolet rays under the conditions of an illuminance of 220 mW/cm² and a light amount of 160 mJ/cm² using an ultraviolet irradiation apparatus ("Adwill RAD 2000/m12" manufactured by Lintec Corporation). Then, using a super cutter ("PH1-600" manufactured by Ogino Seiki Co., Ltd.), the already heated laminated body was cut within 30 seconds to prepare a test piece having a width of 15 mm, a length of 100 mm and a thickness of 203 µm. When the time exceeded 30 seconds during cutting, the cutting was stopped once, and the laminated body under cutting was reheated using a hot plate heated to 80°C and then cut within 30 seconds to prepare test pieces. The reason why the laminated body is cut after heating as described above is to prevent the occurrence of a defect portion which causes breakage at the end portion of the test piece.

Then, using a universal testing machine ("Autograph AG-IS 500N" manufactured by Shimadzu Corporation), the test piece was fixed at two places using the fixed gripping tool thereof. At this time, the distance between the tip portions of the fixed gripping tool (the length of the exposed portion of the test piece, the distance between the fixed places) was 75 mm. Further, the test piece was pulled within the fixed places with a tension rate of 200 mm/min to measure the breaking elongation (%) of the test piece. The results are shown in the columns of "breaking elongation before curing" in Tables 2 and 3.

### (Evaluation of pick-up suitability)

An 8-inch silicon wafer was singulated into chips of 2 mm × 2 mm and 50 µm in thickness, and the film-like adhesive of the sample for evaluation obtained using the film-like adhesive composite sheet described above was adhered to the dry polished surfaces thereof by using a laminator at 60°C. Thereafter, ultraviolet rays were irradiated under the conditions of an illuminance of 220 mW/cm² and a light amount of 160 mJ/cm² using an ultraviolet irradiation apparatus ("Adwill RAD 2000/m12" manufactured by Lintec Corporation) with respect to the film-like adhesive composite sheet of Example 2, and under the conditions of an illuminance of 200 mW/cm² and a light amount of 160 mJ/cm² using an ultraviolet irradiation apparatus ("Adwill RAD 2000/m12" manufactured by Lintec Corporation) with respect to the film-like adhesive composite sheet of Example 4, respectively.

In this manner, with respect to a sheet obtained by adhering a film-like adhesive of one film-like adhesive composite sheet to a plurality of chips, using a pickup device ("BESTEM-D 02" manufactured by Canon Machinery Inc.), chips with the film-like adhesive were picked up 54 times by a 1 pin thrusting method under the conditions of a push-up amount of 150 µm, a push-up rate of 20 mm/min and a lifting latency of 1 second. Further, when the pick-up operation succeeded 54 times, the pick-up suitability was evaluated as good (○), and when the pick-up operation did not succeed one or more times, the pick-up suitability was evaluated as poor (x). In the case of poor pick-up suitability, the details of the abnormality which caused it were classified into the occurrence of doubled dies and the lifting failure, and the frequency (%) was calculated by counting the number of occurrences of these abnormalities. The results are shown in Tables 2 and 3.

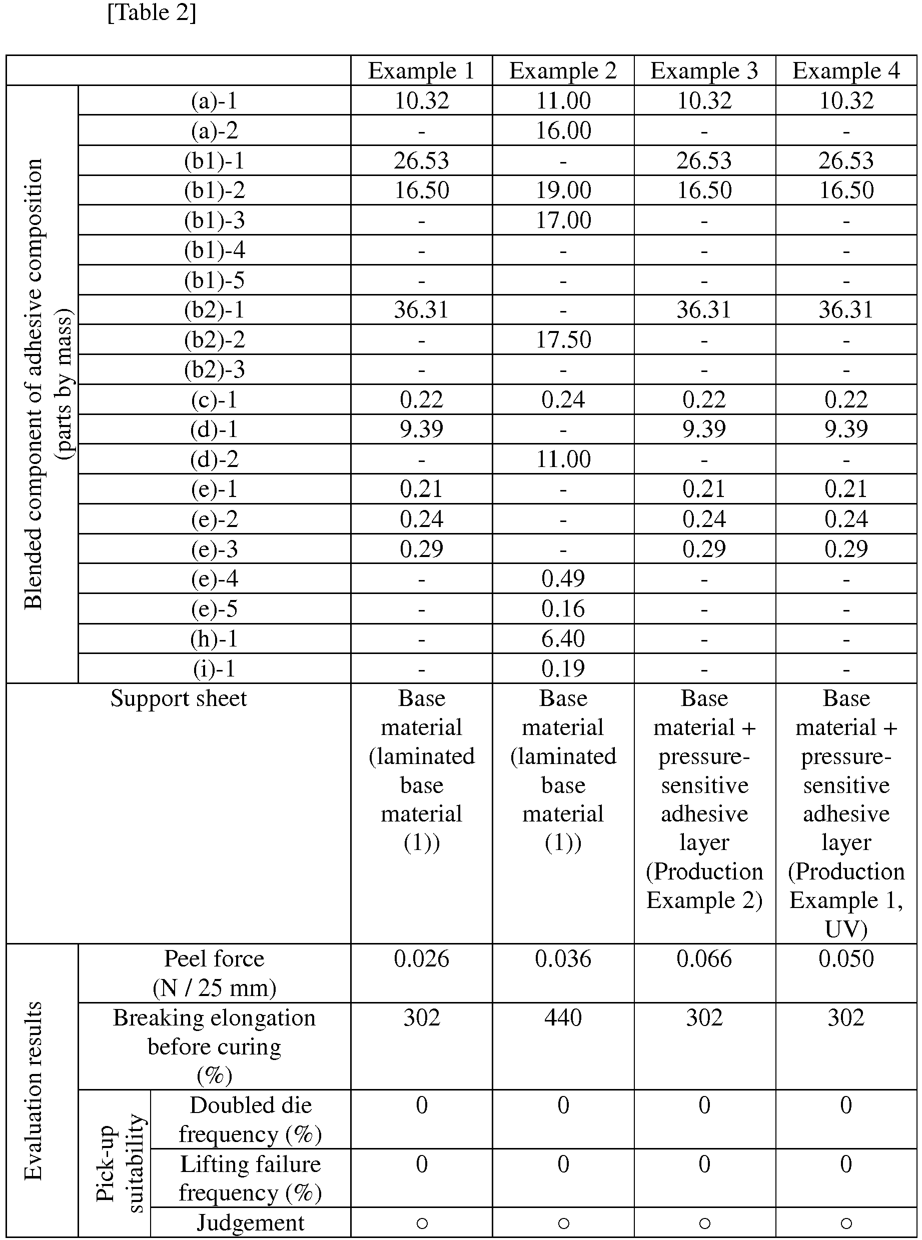

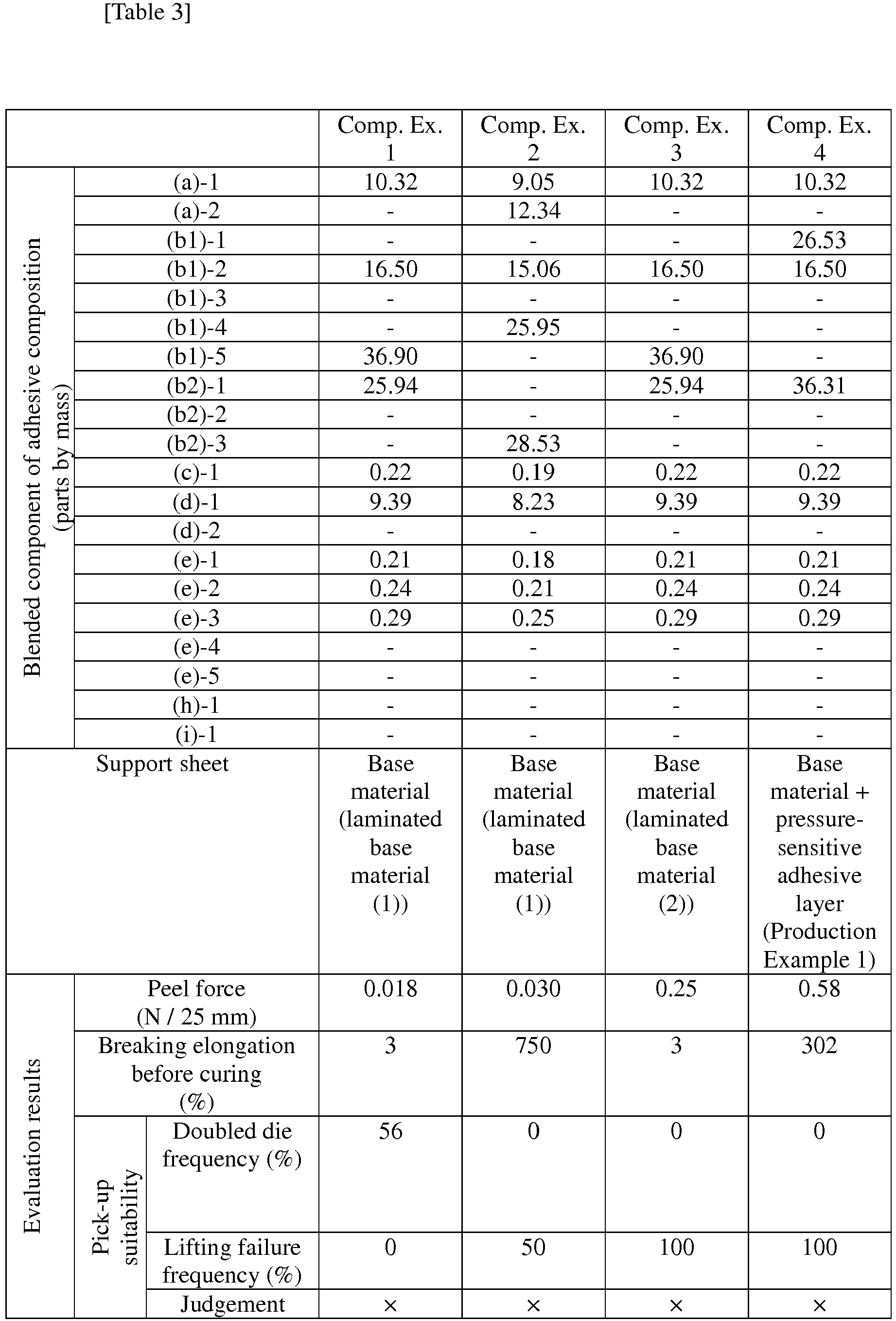

As is apparent from the above results, in the film-like adhesive composite sheets of Examples 1 to 4, since the thickness of the film-like adhesive, the peel force and the breaking elongation were all within predetermined ranges, it was possible to cut the film-like adhesive without separately providing a step mainly for cutting the film-like adhesive at the time of picking up the chips to which the film-like adhesive was adhered, and the it was possible to reliably pick up the chips to which the film-like adhesive was adhered from the support sheet without process abnormality.

On the other hand, in the film-like adhesive composite sheet of Comparative Example 1, since the peel force was too small, doubled dies occurred, and the pick-up suitability was poor.

In addition, in the film-like adhesive composite sheet of Comparative Example 2, since the breaking elongation was too large, the film-like adhesive could not be cut, lifting failures occurred, and the pick-up suitability was poor.

Further, in the film-like adhesive composite sheets of Comparative Examples 3 and 4, since the peel force was too large, the film-like adhesive could not be separated from the base material (support sheet), lifting failures occurred, and the pick-up suitability was poor.

The configurations, combinations thereof, and the like in the respective embodiments are merely examples, and additions, omissions, substitutions, and other modifications of the configurations are possible without departing from the spirit of the present invention. Further, the present invention is not limited by each embodiment, but is limited only by the scope of the claims.

### Industrial Applicability

The present invention can be used for manufacturing a semiconductor device.

### Reference Signs List

1, 2: Film-like adhesive composite sheet; 10: Base material; 11: Support sheet; 11a: Front surface of support sheet; 11b: Back surface of support sheet; 12: Film-like adhesive; 13: Pressure-sensitive adhesive layer; 9: Semiconductor chip; 9b: Back surface of semiconductor chip

## Claims

1. A film-like adhesive composite sheet comprising:
a support sheet having a base material; and
curable film-like adhesive provided on said support sheet and having a thickness of 1 to 50 µm,
wherein a peel force at an interface between said support sheet and said film-like adhesive is from 0.02 to 0.2 N / 25 mm, and
said film-like adhesive has the following properties:
a breaking elongation of a laminated body obtained by laminating said film-like adhesive before curing so that the total thickness becomes 200 µm is equal to or less than 450%.

2. The film-like adhesive composite sheet according to Claim 1,
wherein said support sheet is composed of said base material, and said film-like adhesive is provided on and in direct contact with said base material.

3. The film-like adhesive composite sheet according to Claim 1 or 2,
wherein a peel force at an interface between said support sheet and said film-like adhesive in a state where said film-like adhesive composite sheet is not irradiated with an energy ray is from 0.02 to 0.2 N / 25 mm.

4. A method for manufacturing a semiconductor device, the method comprising:
a step of adhering the film-like adhesive composite sheet according to any one of Claims 1 to 3 to a plurality of already divided semiconductor chips via a film-like adhesive;
a step of applying a force to a support sheet of said film-like adhesive composite sheet adhered to said semiconductor chip from a side opposite to a side provided with the film-like adhesive, thereby applying a force to the film-like adhesive through the support sheet and cutting the film-like adhesive; and
a step of separating said semiconductor chip and said film-like adhesive after cutting and adhered thereon from said support sheet.
